# EUROPEAN PATENT SPECIFICATION

(11) **EP 0 764 352 B1**
(45) Date of publication and mention of the grant of the patent: **19.05.2004**
(21) Application number: 95923103.6
(22) Date of filing: 07.06.1995
(51) Int. Cl.: H01R 12/04, H01R 12/32, H05K 3/32, H01L 23/498, H01R 12/16, H05K 7/10

(54) **MICROELECTRONIC CONTACTS AND ASSEMBLIES**
MIKROELEKTRONISCHE KONTAKTE UND ZUSAMMENBAUTEN
CONTACTS ET ASSEMBLAGES MICROELECTRONIQUES

(30) Priority: 07.06.1994 US 254991; 14.09.1994 US 306205; 24.03.1995 US 410324
(43) Date of publication of application: 26.03.1997
(60) Divisional application: 04002310.3
(73) Proprietor: TESSERA, INC., San Jose, CA 95134 (US)
(72) Inventor: FJELSTAD, Joseph, Sunnyvale, CA 94086 (US); SMITH, John, W., Palo Alto, CA 94301 (US); DISTEFANO, Thomas, H., Monte Sereno, CA 95030 (US); WALTON, A., Christian, Belmont, CA 94002 (US); ZACCARDI, James, San Jose,CA 95134 (US)
(74) Representative: Harrison, Michael Charles
(86) International application number: PCT/US1995/007901
(87) International publication number: WO 1995/034106

(56) References cited:
- EP-A- 0 453 716
- EP-A- 0 529 577
- US-A- 3 275 736
- US-A- 3 670 409
- US-A- 4 676 564
- US-A- 4 950 173
- US-A- 4 975 079
- US-A- 5 056 216
- US-A- 5 152 695
- US-A- 5 161 729
- US-A- 5 181 859
- US-A- 5 199 879
- US-A- 5 239 127
- PATENT ABSTRACTS OF JAPAN vol. 018, no. 340 (E-1569), 27 June 1994 (1994-06-27) -& JP 06 085425 A (NEC CORP), 25 March 1994 (1994-03-25)
- PATENT ABSTRACTS OF JAPAN vol. 006, no. 243 (E-145), 2 December 1982 (1982-12-02) -& JP 57 143838 A (MITSUBISHI DENKI KK), 6 September 1982 (1982-09-06)

## Description

### TECHNICAL FIELD

The present invention relates to contacts and components useful for mounting semiconductor chips and related electronic components; to assemblies made using such components and to methods of making such contacts, components and assemblies.

### BACKGROUND OF THE INVENTION

Microelectronic circuits require numerous connections between elements. For example, a semiconductor chip may be connected to a small circuit panel or substrate, whereas the substrate may in turn be connected to a larger circuit panel. The chip to substrate or "first level" interconnection requires a large number of individual electrical input and output ("I/O") as well as power and ground connections. As chips have become progressively more complex, the number of I/O connections per chip has grown so that hundreds of connections or more may be needed for a single chip. To provide a compact assembly, all of these connections must be made within a relatively small area, desirably an area about the area of the chip itself. Thus, the connections must be densely packed, preferably in an array of contacts on a regular grid, commonly referred to as a "Bump Grid Array" or "BGA". The preferred center-to-center distance between contacts or "contact pitch" for chip mountings is on the order of 1.5 mm or less, and in some cases as small as 0.5 mm. These contact pitches are expected to decrease further. Likewise, chip mounting substrates and other circuit panels used in microelectronics have become progressively more miniaturized, with progressively greater numbers of electrical conductors per unit area. Connectors for these miniaturized panel structures desirably also have very small contact pitch. Connections of chip mounting substrates to other elements are referred to as "second-level" inter connections.

In some cases, the connections may include permanent metallurgical bonding of the mating contacts to one another, as by soldering, brazing, thermocompression or thermosonic bonding, welding and the like. For example, electrical contacts on a semiconductor chip may be bonded to the mating contact pads of a substrate by solder bumps. Alternatively, the connection may be made so that the mechanical interengagement of the mating elements provides electrical continuity. Such a connection usually is separable, so that the connected elements can be removed. For example, contacts on a chip may be temporarily engaged with mating contacts of a test fixture under mechanical load.

Microelectronic connections must meet numerous, often conflicting requirements. As mentioned above, the size of the device poses a major concern. Further, such connections often are subject to thermal cycling strains as temperatures within the assembly change. The electrical power dissipated within a chip or other microelectronic element tends to heat the elements so that the temperatures of the mating elements rise and fall each time the device is turned on and off. As the temperatures change, the various connected elements expand and contract by different amounts, tending to move the contacts on one element relative to the mating contacts on the other element. Changes in the temperature of the surrounding environment can cause similar effects.

The connections must also accommodate manufacturing tolerances in the contacts themselves and in the connected elements. Such tolerances may cause varying degrees of misalignment. Additionally, contamination on the surfaces of the mating contact parts can interfere with the connection. This can occur in metallurgically bonded connections and, particularly, in mechanically interengaged connections. Therefore, the contact system should be arranged to counteract the effects of such contaminants.

Also, in making soldered connections, oxides and other contaminants must be removed by fluxes. These fluxes in turn can contaminate the finished product. Although these fluxes can be removed by additional cleaning steps, or can be formulated to minimize ill-effects on the finished product, it would be desirable to provide soldered connections which minimize or eliminate the need for such fluxes. All of these requirements, taken together, present a formidable engineering challenge.

Moreover, despite all of the efforts made during made during manufacture of the chips, some chips will be defective. These defects often cannot be detected until the chip is operated under power in a test fixture or in an actual assembly. A single bad chip can make a larger assembly including numerous chips and other valuable components worthless, or can require painstaking procedures to extricate the bad chip from the assembly. Therefore, the chips and the mounting components used in any chip assembly system should permit testing of chips and replacement of defective chips before the chips are fused to a substrate. The cost of the chip and substrate assembly is also a major concern.

Various attempts have been made heretofore to provide first-level interconnection structures and methods to meet these concerns. At present, the most widely utilized primary interconnection methods are wire bonding, tape automated bonding or "TAB" and flip-chip bonding.

In wire bonding, fine wires are connected between contacts on the face of the chip and contact pads on a substrate. The wire bonding process does not provide any pre-testing of the chip. Thus, the bare chip must be tested using separate equipment before the wire bonding process. Testing a bare chip poses numerous practical difficulties. It is difficult to make reliable low inductance electrical connections with all of the contacts on the chip simultaneously. U.S. Patent Nos. 5,123,850 and 4,783,719 disclose chip testing fixtures in which conductive elements on a flexible device are pressed against electrical contacts of the chip.

In the TAB process, a polymer tape is provided with thin layers of metallic material forming conductors on a first surface of the tape. The contacts on the chip are bonded to the conductors on the tape. U.S. Patent Nos. 4,597,617 and No. 5,053,922 disclose variants of the TAB process in which the outer ends of the leads on the tape are placed in contact with the substrate by mechanical pressure, rather than by metallurgical bonding.

In flip-chip bonding, contacts on the front surface of the chip are provided with bump leads such as balls of solder protruding from the front surface of the chip. The substrate has contact pads arranged in an array corresponding to the array of contacts on the chip. The chip, with the solder bumps, is inverted so that its front surface faces toward the top surface of the substrate, with each contact and solder bump on the chip being positioned on the appropriate contact pad of the substrate. The assembly is then heated so as to liquefy the solder and bond each contact on the chip to the confronting contact pad of the substrate. Flip-chip bonding is well suited to use with chips having large numbers of I/O contacts. However, assemblies made by flip-chip bonding are quite susceptible to thermal stresses. The solder interconnections are relatively inflexible, and may be subjected to very high stress upon differential expansion of the chip and substrate. These difficulties are particularly pronounced with relatively large chips. Moreover, it has been difficult to test a chip having an area array of contacts before attaching the chip to the substrate.

U.S. Patent Nos. 4,893,172 and 5,086,337, disclose variants of the flip-chip approach using flexible spring-like elements connected between a chip and a substrate. U.S. Patent No. 5,196,726 discloses a variant of the flip-chip approach in which non-meltable bump leads on the face of the chip are received in a cup-like sockets on the substrate and bonded therein by a low-melting point material. U.S. Patent No. 4,975,079 discloses a test socket for chips in which dome-shaped contacts on the test substrate are disposed within conical guides.

U.S. Patent No. 4,818,728 discloses a first substrate such as a chip with studs or bump leads protruding outwardly and a second substrate with recesses having solder for engaging the bump leads. U.S. Patent No. 5,006,792 and Nolan et al, A Tab Tape-Based Bare Chip Test and Burn Carrier, 1994 ITAP And Flip Chip Proceedings, pp. 173-179 disclose sockets with cantilevered contact fingers for engaging the contacts on a chip. Hill et al, Mechanical Interconnection System For Solder Bump Dice, 1994 ITAP And Flip Chip Proceedings PP. 82-86, discloses a test socket for flip chip devices with solder bumps. The socket has rough, dendritic structures on contact pads; here again, the chip with the solder bumps thereon is forced into the engagement with the rough, dendritic structures so as to make temporary contact for testing.

The reference "MCM to Printed Wiring Board (Second Level) Connection Technology Options" by Alan D. Knight, (in Multichip Module Technologies and Alternatives, ed. by Daryl Ann Doane and Paul D. Franzon, Van Nostrand, 1993, pp. 504-509 and pp. 521-523), together with U.S. Patent Nos. 4,655,519; 5,228,861; 5,173,055; 5,152,695; and 5,131,852, as well as U.S. Patent Nos. 4,716,049; 4,902,606; and 4,924,353, disclose additional connection systems using deformable contacts. Connectors of the type having a body with numerous holes and also having contacts associated with these holes are disclosed in U.S. Patent Nos. 4,950,173; 3,275,736; 3,670,409 and 5,181,859, as well as in the article "Quieting Connectors Down", Electronic Buyers' News, Issue 867, August 16, 1993. Various connectors using bumped or roughened elements are disclosed in U.S. Patent Nos. 5,046,953; 4,846,704; 3,818,415; 5,006,517 and 5,207,585.

Despite all of these efforts in the art however, there have still been needs for improved components for connecting semiconductor chips and other microelectronic components; for improved methods for connecting such chips and components and for improved systems which include the connected chips and components.

### SUMMARY OF THE INVENTION

The present invention addresses these needs.

One aspect of the present invention provides a sheet socket component for mounting a microelectronic element such as a semi-conductor chip or other element to a substrate. The sheet socket component or connector according to this aspect of the invention as defined in claim 1 desirably includes a planar or sheet like dielectric body having first and second surfaces and also having a plurality of holes open to the first surface. The holes are disposed in an array corresponding to an array of bump leads on the device to be mounted. The connection further includes an array of resilient contacts secured to the first surface of the dielectric body in registration with the holes so that each such contact extends over one hole. Each contact is adapted to resiliently engage a bump lead inserted into the associated hole. The connection also includes terminals electrically connected to these contacts. Typically, the terminals are disposed in an array on the second surface of the dielectric body. Thus, the terminals may be connected to the associated contacts by leads, such as hollow barrels or vias extending through the dielectric body. A chip or other microelectronic element with the bump leads thereon can be connected to a substrate. The terminals of the connector are connected to the electrical circuit of the substrate. The microelectronic element is superposed on the dielectric body of the connector so that the microelectronic element overlies the first surface and so that the bump leads on the element protrude into the holes and are engaged by the resilient contacts. Preferred connector components according to this aspect of the invention will establish electrical connection with the bump leads and by mechanical inter-engagement of the bump leads and contacts.

Each contact may include a structure such as a ring of a sheet-like metallic contact material overlying the first surface of the dielectric body and encircling the opening of the associated hole, and each contact may also include one or more projections formed integrally with the ring and extending inwardly therefrom over the hole. Preferably, a plurality of such projections are provided at circumferentially-spaced locations around the hole. These projections are arranged so that when a bump lead enters the hole, it tends to force the projections outwardly, away from one another, thereby acting to center the bump in the hole. As further discussed below, such arrangements can provide reliable electrical interconnection of the bump leads with the contacts. The chip or other microelectronic component can be reliably interconnected to the substrate simply by pressing the chip against the connector in proper alignment with the holes. This reliable interconnection can be used either as a temporary interconnection for testing purposes or as a permanent connection between the chip and the substrate. Preferably, the motion of the bump leads entering the holes as the microelectronic element is engaged with the connector wipe across the contacts so as to clean debris, oxides and other contaminants from the surfaces of the contact and bump lead. Most preferably, the contacts are provided with protruding asperities, and each asperity has a sharp feature such as a sharp edge or point. The sharp features of the asperities scrape the mating bump leads during the wiping action. The bump leads on the chips may be substantially spherical balls such as balls coated with solder or another bonding material, or else may be cylindrical conical or other projections from the surface of the microelectronic element. Additionally, the contacts may be adapted to bond with the bump leads on the chip. Thus, the contact may themselves carry a heat-activatable bonding material such as eutectic alloy, solder, diffusion bonding alloy or the like arranged to bond with the bump leads. Alternatively or additionally, the contacts can be formed from a material which is compatible with a bonding material carried by the bump leads. Such bonding will provide a permanent metallurgical connection. Thus, the chip can be engaged in with the connector and substrate mechanically and tested using the mechanically-made electrical interconnections. If the results are satisfactory, the permanent metallurgical bond can be formed. In a particularly preferred arrangement, the bump leads are formed from a heat-softenable bonding material such as a solder. When heat is applied after engagement of the bump leads and contacts, the tips of the contacts spring back and penetrate the solder, leaving the tips embedded in contaminant-free solder. This permits flux-free bonding.

The sheet like connector body of the sheet socket may be less than about 1 mm thick and the holes in the body may extend entirely through the body, from the first surface to the second surface. Thus, the connector does not add appreciably to the thickness of the assembly; the spacing between the chip or other element and the underlying substrate will be approximately the same as the spacing achieved by direct, flip-chip bonding of bump leads to the substrate. The holes may be closely spaced, at intervals of less than about 2.5 mm, preferably less than about 1.5 mm and more preferably about 1.0 mm or less.

The holes may extend through the body so that each hole has a first surface end and a second surface end. Each terminal may be disposed on the second surface of the connector body at the second surface end of such hole. The connector may further include through conductors extending within each hole. The contact at the first surface end of each hole may be connected to the terminal at the second surface end of the hole by the through conductor extending within the hole. Most preferably, each such through conductor is a hollow, conductive via liner substantially lining the wall of the associated hole. This arrangement provides an extraordinarily compact device. The pitch or distance between holes may be on the order of three times, or more preferably, two times the diameter of the bump leads to be received or even less. Although this arrangement can be used with any pitch, it is especially advantageous where the pitch is about 1.5 mm or less.

Most preferably, each via liner is metallic and has a contact support portion flaring outwardly, away from the center of the associated hole at the first surface end of the hole. Each contact desirably includes a ring-like structure of a laminar metallic contact material, the ring overlying the contact support of the associated via liner and encircling the opening of the hole at the first surface. Each ring desirably is connected to the contact support remote from the hole, i.e., adjacent to the periphery of the contact support. Each such contact may also include at least one projection, and desirably a plurality of projections, formed integrally with the ring and extending inwardly therefrom so that the projections extend over the hole. Each contact support may include an attachment means such as a plurality of plated vias or posts protruding upwardly, away from the contact support on the connector body, and connecting the contact electrically and mechanically to the contact support at positions remote from the hole. Each attachment may include a locking protrusion overlying the ring portion of the associated contact so as to lock the ring to the contact support. Preferably, the rings and the contact supports are polygonal, most preferably square, and the metal vias or posts are disposed adjacent the corners of the polygon.

A further aspect of the present invention provides a method of making connections to a microelectronic element having bump leads thereon. The method according to this aspect of the present invention as defined in claim 19 desirably include the step of engaging the microelectronic element with a sheet socket connector having a sheet-like dielectric body and having contacts on a first major surface thereof extending over holes in the body. The engagement step is performed so that the first major surface of the connector body is juxtaposed with the microelectronic element, so that the bump leads on the microelectronic element protrude into the holes in the connector body and hence through the first surface over the connector body, and so that the bump leads deform the contacts of the connector and are engaged therewith. Most preferably, the connector body closely overlies a substrate prior to the aforementioned engaging step, so that the connector forms part of the mounting assembly and so that the first surface of the connector body constitutes an exposed mounting surface of the mounting assembly. Moreover, prior to the engaging step, the contacts on the connectors desirably are connected electrically to the substrate, so that when the microelectronic element is engaged with the connector, it will be both physically juxtaposed with the mounting assembly and electrically connected thereto. The method further includes the step of bonding the bump leads to the contacts by activating an electrically conductive bonding material at interfaces between the bump leads and the contacts, as by momentarily heating the microelectronic element and the connector so as to cause a bonding material already present on the contacts and/or on the bump leads to form a flowable phase at interfaces between the bump leads and contacts.

The method desirably includes the step of electrically testing the assembled microelectronic element, connector and substrate prior to the bonding step by actuating the microelectronic element through electrical circuitry of the substrate and through the connections between the contacts and the bump leads. Thus, the assembly can be made by positioning the microelectronic element in place on the sheet socket connector mounted to the substrate and then tested. If the assembly is acceptable, the metallurgically bonded connections can be made without disengaging the microelectronic element from the connector. The assembly can be used as is, without forming the metallurgically bonded connections, leaving the microelectronic elements permanently mechanically and electrically engaged to the sheet socket connector. If the assembly is not acceptable, the microelectronic element can be separated from the remainder of the assembly and replaced by another microelectronic element. Alternatively, if the other parts of the assembly are defective, the microelectronic element can be salvaged.

The ability to test the completed assembly and replace defective parts before forming the metallurgical bonds is particularly useful where a plurality of microelectronic components are to be connected to a common substrate as, for example, in a complex hybrid circuit or module. Most preferably, the engaging step includes the step of engaging a plurality of microelectronic elements with the connector, and hence with the substrate in the same manner as described above, as by forcing the bump leads on each of the components into holes in the connector first surface so as to engage the bump leads with the contacts of the connector. After the entire assembly is tested as a unit and found acceptable, metallurgical bonds can be formed to the bump leads of all of these components in a single bonding step, as by heating the entire assemblage. Alternatively, the assembly can be operated without the step of forming a metallurgical bond between the microelectronic elements and the connector.

These aspects of the invention provide extraordinary versatility and the ability to connect many different devices. This versatility can be extended by prefabricating subassemblies including one or more electronic devices on a carrier with a generally planar undersurface and electrically connecting the devices on the carrier to bump leads projecting from the undersurface of the carrier so as to form the composite microelectronic element. Such an element can be engaged with the connector and substrate in the processes as aforesaid. In further extensions of the process, the same sheet socket connector can be used to connect the substrate to a cable, to a test fixture, to another substrate or to a larger "mother board" by use of appropriate interconnect devices such as plugs which are engaged with the connector in the same manner as the microelectronic elements. Thus, the present invention provides a complete system usable for connecting electronic elements in a wide variety of configurations. Further, the system can make use of essentially any standard pitch or spacing between bump leads; the holes in the connectors are provided at the appropriate spacings to match the standard pitch.

Yet another aspect of the invention provides an electronic assembly or system as defined in claim 33. The system preferably includes a mounting assembly as aforementioned and at least one microelectronic element. Each such microelectronic element has a bottom surface and a plurality of bump leads protruding from the bottom surface. Each such microelectronic element is mounted on the mounting assembly with the bottom surface of the element confronting a mounting surface of the mounting assembly, the bump leads of the element protruding into the holes of the mounting assembly at such mounting surface and engaging electrical contacts on the mounting assembly at these holes so that the bump leads are electrically connected to leads of the mounting assembly through the contacts. Such a system or assembly preferably includes plural microelectronic elements interconnected to one another through the leads of the mounting assembly. The bump leads may be either bonded to the contacts of the mounting assembly or else may be releasably engaged with the contacts, as by mechanical interengagement. Assemblies according to this aspect of the present invention can be fabricated readily, with high reliability and with extraordinary compactness.

A further example provides a contact for a microelectronic device. The contact according to this example includes a base portion defining a base surface, and one or more asperities preferably integral with the base portion and protruding upwardly from the base surface to a height of less than about 40 microns, more preferably less than about 25 microns. Each such asperity defines a tip surface remote from the base surface and a substantially sharp edge bounding the tip surface. Each asperity desirably includes a column of a first metal extending upwardly from the base surface. Each asperity may also include a cap of a second metal defining the sharp edge and the tip surface. The second metal preferably is a substantially etch-resistant metal, and may be harder than the first metal. The second metal may be selected from the group consisting of gold, osmium, rhenium, platinum, palladium and alloys and combinations thereof. Alternatively or additionally, the tip surfaces of the asperities may carry electrically conductive bonding materials adapted to form metallurgical bonds with time mating electrical elements. Preferably, the tip surfaces of the asperities are substantially flat, and hence provide appreciable surface for carrying the bonding material. The first metal may be selected from the group consisting of copper and copper-bearing alloys. The base portion of each contact may include one or more metallic layers such as copper or copper-bearing alloys, and preferably includes a metal having resilient characteristics such as beryllium copper or phosphor bronze. Alternatively, the base portion of each contact may include a polymeric structural layer in addition to a conductive, desirably metallic, layer.

Each asperity may be substantially cylindrical, most preferably in the form of a right circular cylinder, and each of the aforementioned sharp edges may be substantially in the form of a circle encircling the tip of the asperity. The base portion of each contact may include an anchor region and at least one tab or projection formed integrally with the anchor region. The asperity or asperities may be disposed on each tab remote from the anchor region. In use, the anchor region of such a contact is fixed to a connector body or other support, whereas the tab is free to bend. When a lead, contact pad or other mating electrical element is engaged with the tab, the tab bends and the mating element and tab move relative to one another to provide a wiping motion. The resilience of the tab causes the sharp edge of the asperity to bear on the mating element and scrape the mating element. The anchor region of each contact may be part of a substantially ring-like common anchor region. A contact unit may include such common anchor region and a plurality of tabs extending inwardly from the ring-like anchor region towards a common center. Such contact units can be employed in connectors and methods as discussed above.

Further examples include connectors including the contacts discussed above. Thus, a connector according to this aspect of the invention may include a contact having a base portion and one or more asperities thereon, each asperity having a tip surface and a substantially sharp edge bounding the tip surface, the contact being mounted to the body so that when a mating element is engaged with the contact, the mating contact element will be wiped across the asperity and pressed against the asperity, causing the sharp edge of the asperity to scrape the mating contact element. Preferably, the anchor region of the contact is secured to the body and the projection is free to flex. In this arrangement, the resilience of the projection causes the asperity to engage the mating element. Where a contact unit includes a ring-like anchor region and plural tabs extending inwardly therefrom, the contact unit may be mounted to the body of the connector so that the ring-like anchor region extends around a hole and so that the tabs extend inwardly over the hole, with the asperities pointing generally up, away from the body. When the mating contact element is forced into the hole, the tabs bend downwardly and the asperities engage the mating contact element.

A further example provides a connector including a plurality of contact base portions, said base portions being disposed in a regular contact pattern. Each contact base portion defines a base surface. The contact assembly further includes a plurality of asperities, each such asperity protruding upwardly from the base surface of the associated contact base portion. Each such asperity has a tip remote from the base surface and a substantially sharp feature at such tip. The asperities may be disposed in a regular, predetermined asperity pattern. The asperity pattern is in registration with the contact pattern so that at least one asperity is disposed on each contact base portion. The contact base portions may be substantially identical to one another and the asperities may be disposed in substantially the same location on each such contact base portion.

In connectors according to this example, the regular distribution of asperities on the contact portions assures that the asperities are present on most or all of the contact portions even where the spacings between adjacent asperities are large relative to the size of the contact portions themselves. Stated another way, there is no need to pack the surface with closely spaced asperities in order to assure that each contact portion is provided with an asperity. Accordingly, each asperity may stand out from the base surface unencumbered by surrounding asperities This promotes effective scraping action, particularly in the case of very small contacts and asperities.

A further example provides methods of engaging a microelectronic element with a connector. Such methods include the step of moving the microelectronic element relative to the body of the connector so that asperities carried on contacts included in the connector scrape electrical elements, such as leads or contact pads, on the sharp edges on the tips of the asperities engage and scrape the conduct element of the microelectronic device. Preferably, the contact portions include flexible tabs and the asperities are disposed on the flexible tabs. During the engagement step, the tabs are distorted by engagement with the mating electrical mating elements of the microelectronic device, so that the projections urge the asperities into engagement with the contact elements. The method according to this example may further include the step of forming a permanent metallurgical bond between the contacts and the terminals of the microelectronic element. The bonding step can be performed by activating an electrically conductive material carried by the contacts or by the engaged elements of the microelectronic device. Alternatively or additionally, the method may include the step of actuating the microelectronic element by applying signals through the contacts and the engaged elements of the microelectronic device without formation of a metallurgical bond or before such a bond is formed. Thus, the microelectronic element and its engagement with the contacts can be tested before permanent bonding. Here again, the scraping action provided by the sharp features on the asperities promotes reliable contact before bonding, as well as reliable bonding.

Further examples provide methods of making microelectronic contacts. One method according to this example desirably includes the step of depositing an etch-resistant material in a plurality of spots on a top surface of a sheet which includes a first metal at the top surface and then etching the first metal in a first etching process so that at least a portion of the first metal is removed in areas other than said spots, so that the etched areas defines a base surface and so that areas covered by the spots form asperities projecting upwardly from the base surface. The depositing and etching steps form tips on the asperities, remote from the base surface, and also forms substantially sharp edges bounding the tips. The etch resistant material may be a second metal and the second metal may at least partially define the sharp edges of the tips. The second metal may be a metal selected from the group consisting of gold, osmium, rhenium, platinum, palladium alloys and combinations thereof, whereas the first metal desirably is selected from the group consisting of copper and copper-bearing alloys.

The sheet may include a layer of a stop metal resistant to the etchant used to etch the first metal. The stop layer may be formed from a metal such as nickel which is substantially more resistant than the first metal to etching by certain solutions. As further discussed below, the stop layer may be susceptible to etching by other solutions or procedures. The etching step may be continued until the stop metal is exposed in the etched areas, so that the stop metal layer defines the base surface. The method desirably further includes the step of subdividing the sheet into a plurality of contact units, each including one or more contacts, the subdividing and etching steps being conducted so that at least one asperity is disposed on each such contact. The subdividing step may include a further etching process. This further etching process may include the step of etching the sheet from a bottom surface, opposite from the top surface.

Yet another example provides methods of making a microelectronic contact including the steps of etching a sheet incorporating a first metal at such top surface so that at least a portion of the first metal is removed except at locations in a predetermined asperity pattern. Thus, the etched areas define a base surface and asperities project upwardly from the base surface at locations of said asperity pattern. The etching step applied to the top surface is conducted so as to form tips on the asperities remote from the base surface and sharp features at each such tip. The method according to this example desirably also includes the step of severing the sheet according to a predetermined severing pattern, to form a plurality of contact units, each including one or more contacts, the severing pattern and the asperity pattern being in registration with another so that at least one asperity is disposed on each contact. The severing process may be conducted by etching as aforesaid.

Yet another example provides further methods of making an electrical connection. A method according to this example preferably includes the step of forcibly engaging a first element bearing one or more masses of an electrically conductive fusible bonding material such as a solder or other fusible conductive composition and a second element bearing one or more resilient, electrically conductive contacts so that the contact wipes the surface of the mass and so that the contact is deformed and bears against the wiped surface. The method further includes the step of bringing the contact and the mass to an elevated bonding temperature sufficient to soften the fusible bonding material, so that the contact penetrates into the mass under the influence of its own resilience and then cooling the engaged contact and mass. The heating step typically is performed after the engaging step, during the engaging step the solder mass is cool and solid. Most preferably, the engaging step is performed so that the contacts wipe the surfaces of the masses during the engagement step. Most preferably, each contact has one or more asperities on its surface. Typically, the heating and cooling steps are performed by heating and cooling the entire assembly, including both elements.

When the fusible material is heated and softened, and the contacts penetrate into the masses, each contact is exposed to substantially pure fusible material. For example, where the fusible material is a solder, each contact is exposed to substantially pure solder, free of oxides and other impurities found at the solder mass surfaces. This facilitates formation of a sound, metallurgical bond between the solder and the contact. Fluxes need not be utilized to remove the impurities from the surfaces of the solder masses. The contacts may incorporate oxidation-resistant materials at the regions which penetrate into the solder during the process. This further facilitates formation of the solder joint without the use of fluxes.

Although the present invention is not limited by any theory of operation, it is believed that the wiping action tends to rupture the film or layer of oxide which may be present on the surfaces of the solder masses, and thus facilitates penetration of the contacts into the underlying pure solder during the subsequent heating and softening steps. These contacts desirably are provided with sharp-featured asperities in the region which scrape the surfaces of the solder masses.

Still another aspect of the present invention includes bonded articles. An article according to this aspect of the invention includes a first element having a structure with at least one terminal thereon, masses of a bonding material such as a solder and a second element having a body with one or more contacts thereon, each such contact including an anchor portion secured to the body and at least one tab projecting from the anchor portion and having a distal end remote therefrom. The distal end of each such tab projects into one mass of bonding material on the first element and is bonded thereto. Preferably, the bonding material is a solder and the distal end of each tab is metallurgically bonded to the mass. Each tab desirably is bonded to a portion of the mass remote from the surface of the mass. Most preferably, each contact incorporates an annular anchor region defining a central axis and a plurality of tabs projecting inwardly towards such central axis. Each mass is received within the annular anchor portion of one such contact and is penetrated by the radially inwardly extending tabs of such contact. Desirably, tabs penetrate into each mass into many directions, so that the tabs substantially surround the mass. As further discussed below, connections according to this aspect of the invention provide particularly strong interconnections, even where the individual tabs are quite small and hence quite fragile.

The foregoing and other objects, features and advantages of the present invention will be more readily apparent from the detailed description of the preferred embodiments set forth below, taken in conjunction with the accompanying drawings.

### BRIEF DESCRIPTION OF THE DRAWINGS

Figure 1 is a diagrammatic perspective view of a mounting assembly and connectors in accordance with one embodiment of the invention.
Figure 2 is a fragmentary plan view depicting a portion of a connector illustrated in Fig. 1.
Figure 3 is a further fragmentary plan view, on an enlarged scale, depicting a smaller portion of the same connector.
Figure 4 is a diagrammatic sectional view taken along lines 4-4 in Fig. 3.
Figures 5 and 6 are fragmentary sectional views similar to Fig. 4 but depicting the connector, the mounting assembly and a chip during an assembly process.
Figure 7 is a view similar to Fig. 1, but depicting a completed electronic assembly made using the mounting assembly and connectors of Fig. 1.
Figure 8 is a fragmentary sectional view similar to Fig. 4, but depicting a connector in accordance with another embodiment of the invention.
Figure 9 is a fragmentary plan view depicting a part of a connector in accordance with another embodiment of the invention.
Figure 10 is a fragmentary sectional view depicting a part of the connector of Fig. 9 in conjunction with a microelectronic component.
Figure 11 is a fragmentary plan of view similar to Fig. 3, but depicting a portion of a connector in accordance with yet another embodiment of the invention.
Figure 12 is a fragmentary plan view depicting a portion of a connector in accordance with yet another embodiment of the invention.
Figure 13 is a fragmentary sectional view depicting operation of the connector of Fig. 12 during assembly to a microelectronic element.
Figure 14 is a fragmentary, diagrammatic perspective view depicting portions of a contact assembly in accordance with one embodiment of the present invention.
Figure 15 is a fragmentary, diagrammatic partially sectional view on an enlarged scale along lines 15-15 in Fig. 14.
Figure 16 is a view similar to Fig. 15 but illustrating the connector during engagement with microelectronic element.
Figure 17 is a view similar to Fig. 16 but illustrating the connector during one state of a process in accordance with another embodiment of the invention.
Figure 18 is a view similar to Fig. 17 but depicting a later stage of the same process.
Figures 19-23 are fragmentary, diagrammatic sectional views depicting portions of the connector of Figs. 14-18 at stages of a manufacturing process in accordance with a further embodiment of the invention.
Figures 24, 25 and 26 are fragmentary, partially sectional views depicting a connector in accordance with a further embodiment of the invention during successive states of fabrication process.
Figure 27 is a fragmentary, diagrammatic perspective view of a connector in accordance with a further embodiment of the invention.

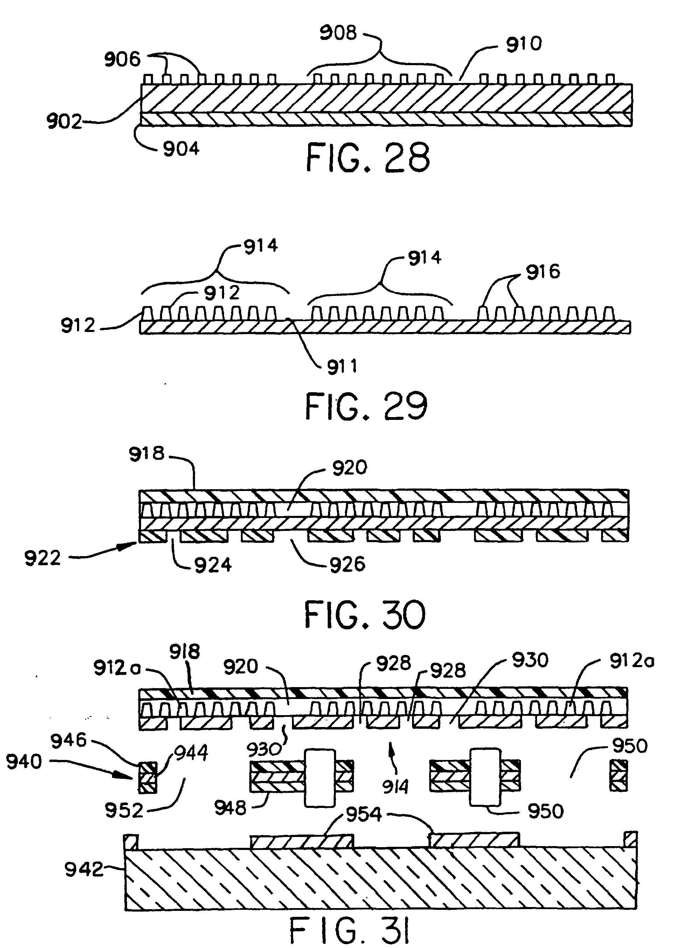

Figures 28 through 32 are fragmentary, diagrammatic sectional views depicting portions of a connector in accordance with a further embodiment of the invention during successive stages of manufacture and use.
Figure 33 is a fragmentary top plan view of a the connector depicted in Figs. 28-32.
Figure 34 is a fragmentary elevational view depicting components used in a further embodiment of the invention.

### DETAILED DESCRIPTION OF THE PREFERRED EMBODIMENTS

A mounting assembly 20 according to one embodiment of the present invention includes a generally planar substrate 21 having a top surface 23 with a first connector 24 disposed thereon and an oppositely facing bottom surface 25 with a second connector 26 on the bottom surface. Substrate 21 in this arrangement is a multi-layer laminated circuit panel with numerous electrical leads 28, of which only a few are schematically indicated. Leads 28 extend in mutually orthogonal, horizontal directions parallel to the top and bottom surfaces. In accordance with conventional semiconductor industry practice, the horizontal directions are referred to as the "x" and "y" directions. The substrate further includes vertical or z-direction leads 56 interconnecting the various horizontal connectors 28. Some of the z-direction leads are exposed at the top surface 23. These exposed leads are disposed in a rectilinear grid of uniform pitch in the x- and y-directions. Exposed leads 56 may include, for example, flowable conductive materials such as solders, eutectic bonding alloys, polymeric materials with metallic fillers and the like, and may also include structures such as vertically extensive vias. The substrate is formed principally from dielectric materials supporting and insulating the leads. Substrate 21 may also include other elements conventional in a multi-layer circuitry, such as ground and power potential planes and the like.

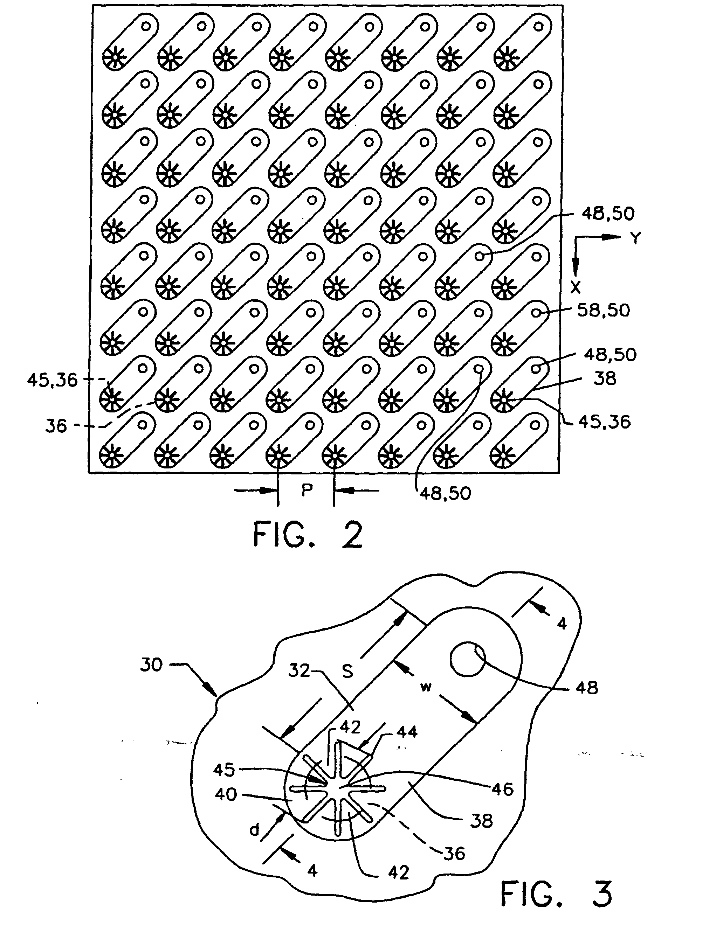

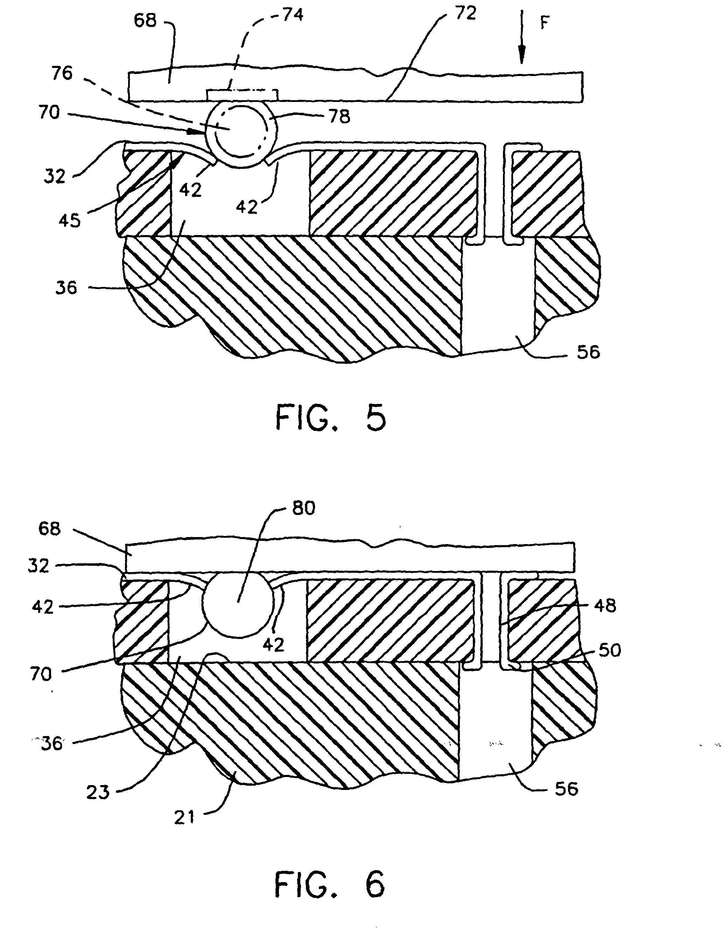

Connector 24 includes a sheet-like dielectric connector body 30 having a first surface 32 facing upwardly, away from the substrate 21 and a second surface 34 facing downwardly, toward the substrate. The connector body 30 has numerous holes 36 (Figs. 2 and 4) extending through it from first surface 32 to second surface 34 and hence extending downwardly to the top surface 23 of the substrate. Connector body 30 is desirably less than about 1 mm thick, more desirably between about 0.5 and about 1.0 mm thick. As further discussed hereinbelow, the connector body thickness should be approximately equal to, or slightly more than, the distance by which the bump leads of the microelectronic elements protrude beyond the surface thereof. Holes 36 desirably are about 0.75 to about 0.80 mm in diameter. As shown in Figs. 3 and 4 an elongated metallic contact tab 38 is associated with each hole 36. Each contact tab overlies the first surface 32 of the connector body. Each contact tab includes a ring-like structure 40 at one end encircling the opening of hole 36 and a plurality of projections 42 extending inwardly from the ring-like element, the projections protruding over the opening of the hole 36. Projections 42 are separated from one another by slots 44. The projections 42 of each contact tab cooperatively define an active contact 45 overlying hole 36 and encircling a central clear opening 46.

As seen in Fig. 4 each contact tab extends to a hollow metallic via 48 extending through the connector body to the second surface 34 thereof. Each such via defines a terminal 50 on the second surface 34 of the connector. As seen in Fig. 2, the holes 36 and active contacts 45 are arranged in rows extending in the x-direction and columns extending in the y-direction. Each contact tab 38 is arranged at an oblique angle, at 45' to the x-direction (and hence 45' to the y-direction), so that each via 48 and hence each terminal 50 is offset in this oblique direction from the active contact 45 and hole 36. Thus, the vias 48 and the terminals 50 at the bottom ends of the vias are also arranged in a rectilinear array of rows and columns extending in the x- and y-directions, but this array is offset from the arrays of holes 36 and active contacts 45. Other oblique angles may be employed.

The rectilinear arrays can have essentially any pitch or spacing between adjacent elements. Preferably, however, the pitch of each array is a pitch which corresponds to a standard pitch for contacts on the surfaces of microelectronic elements such as semi-conductor chips having "area array" contacts. Current standard contacts normally have a pitch P of about 2.5 mm or less between adjacent elements as measured along a row or along a column and more typically about 1.5 mm. The pitch of the via and terminal array should also match the pitch of the array of exposed leads 58 on the substrate.

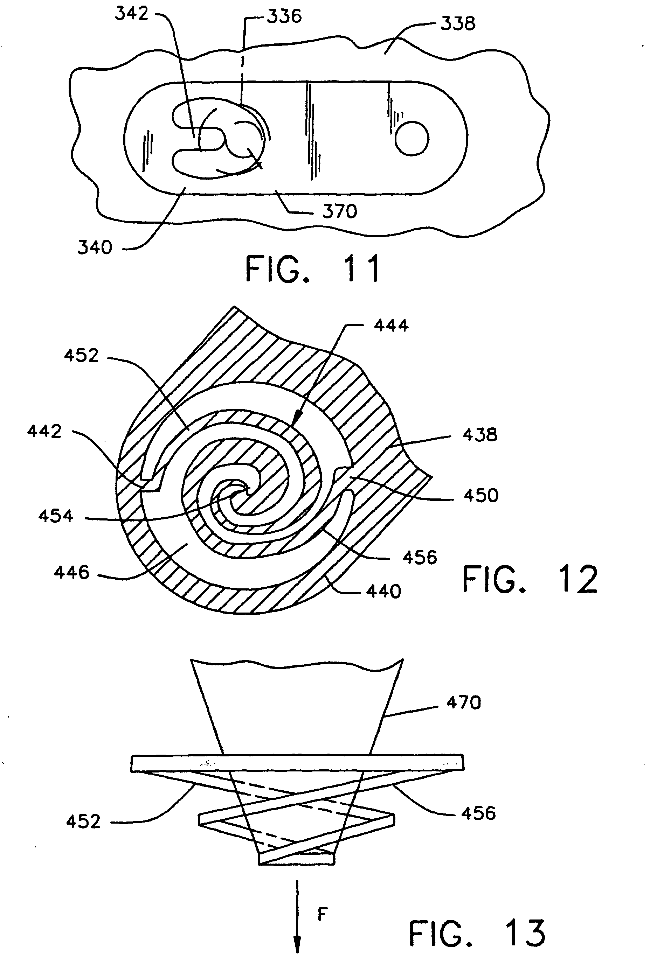

Contact tabs 38, and the projections 42 incorporated therein, are generally laminar. As used in this disclosure, the term "laminar" means sheetlike or platelike. That is, a laminar structure has two oppositely-directed major faces and has edges, the major faces having surface areas substantially greater than the surface areas of the edges. A laminar structure is not necessarily planar. Contact tabs 38 may be formed from metallic materials, preferably those having substantial spring characteristics, good electrical conductivity and good processing properties in etching and plating processes such as those commonly used for microelectronic components. The materials which can be used include copper and copper-bearing alloys such as beryllium copper and phosphor bronze. The metal of the contact tab and of the projection desirably is between about 10 microns and about 50 microns thick. Standard processing techniques can be used to fabricate the contact tabs. However, processes especially adapted for forming projections extending over holes in a dielectric layer are illustrated in United States Patent No. 5,148,266, and particularly at Fig. 13 thereof, the disclosures which are hereby incorporated by reference herein. The dimensions of the components will vary somewhat depending upon the pitch selected and upon the nature of the microelectronic components to be engaged with the connector. However, for a system having pitch of about 1.5 mm, the width W of each contact tab is about 0.9 mm, whereas the length L between the center of the active contact 45 and hole 36 and the center of the associated via 48 may be about 1.0 mm. The radial extent of each slot 44, towards and away from the center of clear region 46 desirably is about 0.63 mm, whereas each slot 44 may be about 0.06 mm wide. The clear central region 46 may have a diameter of about 0.08 mm, whereas the diameter D of the active contact, measured across two radially opposite slots 44 may be about 0.63 mm.

Vias 48 may incorporate metallic or other conductive materials of the types commonly used to form vias in circuit panels. The materials include metals which can be deposited by electroplating or electroless plating and the like, such as copper, nickel, gold and alloys thereof. The terminals 50 may be formed integrally with the via in a standard plating process. Connector 20 is disposed on the top surface of substrate 21 so that the second surface 34 of the connector dielectric body 30 closely overlies the top surface 23 of the substrate. The array of terminals 50 on the second surface of the connector body is disposed in registration with the array of exposed leads 56, so that each terminal 50 is engaged with one exposed lead of the substrate. The terminals 50 and exposed leads 56 are electrically connected to one another. Each exposed lead 56 is connected to internal circuitry within the substrate 21, such as x- and y-direction leads 28. The internal structure of the circuit panel may take any convenient form including, without limitation, the structures illustrated in published International Patent Application No. 92/11395 filed December 30, 1992, the disclosure of which is hereby incorporated by reference herein. Said international application also discloses methods of interconnecting layers of circuitry using flowable conductive materials. These techniques may be used to interconnect connector 24 with the substrate.

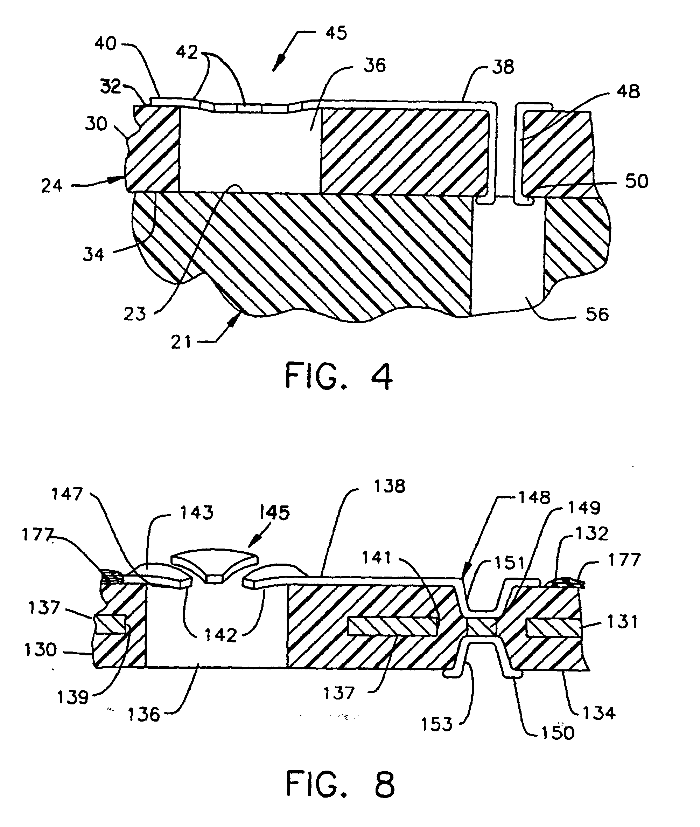

The connector 26 on the bottom surface 25 of the substrate has exactly the same structure as the connector 24 on the top surface of the substrate. In this instance as well, the contact-bearing first surface of the connector dielectric body faces away from the substrate 21; i.e., downwardly, away from the bottom surface 25. Thus, the terminals of the second connector 26 on the bottom surface are electrically connected to further exposed leads (not shown). Substrate 21 and connectors 24 and 26 cooperatively form a unitary mounting assembly 20 with exposed mounting surfaces defined by the first surfaces of the two connectors and with holes extending into the mounting assembly from the surfaces, such as the holes 36 of the first connector. The contacts overlying these holes are electrically connected to conductors within the substrate. The mounting assembly further includes a dielectric mask layer 60 (Fig. 7) overlying parts of the exposed, first surface 32 of the top connector 24. The mask layer covers some of the contacts and some of the holes of the top connector. However, the mask layer has apertures 62, 64 and 66. The positions of the apertures are selected as desired to accommodate the desired mounting positions of various components to be assembled with the mounting assembly. Layer 60 with its apertures can be formed either by die-cutting or etching a sheet of dielectric material, or else can be made by laminating a lithographically formed sheet of dry film dielectric material onto the first surface of the connector. Preferably, layer 60 is formed from a material referred to as "coverlay", which includes a polyimide dielelectric layer and an adhesive layer which serves to fasten the dielectric layer to the connector.

In a connection method, a microelectronic component such as a semiconductor chip 68 is engaged with the connector. Microelectronic element 68 has a plurality of bump leads 70. As best seen in Fig. 5, each bump lead 70 protrudes from the planar bottom surface 72 of element 68. The bump leads are disposed in a rectilinear grid having the same pitch as the grid of active contacts 45 and holes 36 (Fig. 2). In this regard, although the bump leads should be disposed only at the locations defined by such grid, there is no requirement that a bump lead be present at every such location. That is, the grid of bump leads need not be fully populated. For example, the bump leads may be disposed at every other location, every third location, and so on so that the populated locations, with the bump leads have an effective pitch of 2, 3 or some other integral multiple of the pitch of the holes in the connector.

Each bump lead 70 is in the form of a generally spherical ball electrically connected to the internal circuitry 74 of element 68. Bump leads in this generally spherical configuration are sometimes referred to as "ball leads." Each ball lead includes an internal sphere or core 76 formed from an electrically conductive, relatively strong metal such as copper or nickel. Each sphere 76, in turn, is covered with a layer 78 of an electrically conductive, heat-activatable bonding material such as a solder.

Microelectronic element 68 is engaged with the mounting assembly 20, and with the top connector 24 by juxtaposing the element with the mounting assembly so that the contact-bearing surface 72 of the microelectronic element confronts the exposed or first contact-bearing surface 32 of the connector; i.e., so that the contact-bearing surface of the microelectronic element confronts the exposed mounting surface of the mounting assembly defined by the first surface 32 of the connector. The microelectronic element is positioned so that the bump leads 70 are in registration with the active contacts 45 and holes 36 of the connector. Element 68 and mounting assembly 20 are forced towards one another, as by forcing the element 68 downwardly. In this operation, the bump leads 70 engage the projections 42 of each contact and penetrate into holes 36. As this action continues, the bump leads penetrate further into the holes. During this operation, the projections 42 of the contacts bear against the exposed surfaces of the bump leads 70 under their own resilience, so that the projections wipe and scrape the exposed surfaces of the bump leads as the bump leads enter the holes. This action removes debris and oxides from the surfaces of the bump leads and from the surfaces of the projections.

The downward motion of the microelectronic element 68 relative to the mounting assembly and connector continues until the parts reach the position illustrated in Fig. 6. In this position, the contact-bearing surface 72 of element 68 is bottomed on the exposed surface 32 of the connector; i.e., on the mounting surface of the mounting assembly. Also in this position, the center 80 of each ball constituting a bump lead lies below the first surface 32 of the connector and below the projections 42 so that the projections 42 secure the bump lead in position. In this condition, however, the microelectronic element 68 still is not irrevocably secured to the mounting assembly. Nonetheless, the resilient projections 42 make effective electrical contact with each bump lead 70.

Other components are connected to the mounting assembly in the same manner. For example, a further, relatively small substrate or carrier 82 may be provided with further microelectronic elements 84 mounted to substrate 82 by any known technique, such as by surface mount attachment by wire bonding or the like. Thus, the top or exposed surface 86 of carrier 82 may have any desired configuration compatible with the mountings used to attach components 84. The opposite or bottom surface of the carrier (the surface facing towards substrate 21), however, is generally planar and has bump leads 88 identical to the bump leads 70 discussed above. Once again, the bump leads are disposed at locations of a rectilinear grid corresponding to the grid of holes 36 in the mounting surface of the connector body; i.e., the holes in the mounting surface of the mounting assembly. Thus, carrier 82 acts as an adapter, allowing devices having diverse types of contacts to be mounted on the mounting assembly. Carrier 82 is engaged with the contacts of mounting assembly 20 in exactly the same manner as element 68. Likewise, a plug 90 is provided with a generally planar lower surface and with bump leads 92 extending therefrom. The bump leads are electrically connected to conductors of a flat cable 94. Plug 90 may be engaged with mounting assembly 20 in the same manner as carrier 82 and microelectronic element 68. Further, the flat cable plug may have through hole conductors to allow additional plugs to be connected on top of the first in order to form a stack of plugs, each of the contacts of which are electrically connected in parallel. One or more further microelectronic elements 96 are mechanically and electrically connected to mounting assembly 20 by engaging bump leads (not shown) on element 96 with the contacts carried by the lower connector 26 of the mounting assembly. Further elements (not shown) can be engaged with the upper or lower connectors. As illustrated, each of the components engaged with the top connector 20 is disposed within one of the apertures 62, 64, 66. The remaining unused space and holes are blocked by coverlay layer 60 and by a similar layer on the lower connector.

In this condition, all of the components are fully interconnected with one another and can be fully operated at normal speeds. The testing operation can be conducted by supplying power and applying test signals through cable 94. Alternatively or additionally, mounting assembly 20 may have a special test connection region (not shown) for providing power and test signals. Thus, the entire assembly and easy of the components such as microelectronic element 68 will be tested while in an installed, engaged position on the mounting assembly, with signals and power supplied through the substrate and the connector. If the assembly works properly in such a test, there is excellent assurance that the device will work properly in service. Moreover, the test does not require engagement of the chip or of the bump leads with a special test socket. After test of the assembly, the special test connection is removed from the assembly.

If a defect is found, the defective component or components can be disassembled from the mounting assembly simply by pulling the component away from the mounting assembly so as to disengage the bump leads on the component from the contacts. The contacts can be reused by the next component. If no defect is found, the assembly can be used in service without further processing of the connections. The resilient engagement of the contact projections with the bump leads will provide a long-lived electrical connection. Preferably, however, the bump lead are metallurgically bonded to the contacts after the testing step. This can be done by heating the assembly so as to actuate the bonding material on the bump leads and thereby form metallurgical bonds between the bump leads and the contacts. There is no need to remove the microelectronic elements or other components from the mounting assembly, or to alter the engagement between the bump leads and the contacts between the testing step and the bonding step. Accordingly, there is an extremely high probability that, if the assembly tests acceptably in the testing step, it will continue to be acceptable after the metallurgical bonding step. In service, the vias 48, contact tabs 38 and resilient contact projections 42 can deform enough to permit some movement of the bump leads in the x- and y-directions relative to the substrate. This aids in compensating for thermal expansion.

A connector in accordance with a further embodiment of the invention is partially illustrated in Fig. 8. In this case, the dielectric connector body 130 has a sheet-like conductive equipotential plane member 137 disposed between the first surface 132 and the second surface 134 of the connector body. Member 137 may be formed from a conductive material such as copper or other metal, and may be electrically connected to ground or power connections (not shown) to provide a ground or power plane eliminate the space. The holes 136 in connector body 130 extend through apertures 139 in the potential plane member 137, so that bump leads entering into the holes will remain electrically isolated from the potential plane member. The vias or through conductors 148 extend through other apertures 141 in the potential plane member. Each via is a composite structure including a central body 149 of conductive material and a pair of blind vias 151 and 153 extending into central body 149 from the first and second surfaces, respectively, of the connector body. Blind via 153 defines the terminal 150 on the second surface 134 of the connector body.

The active contact region 145 of the contact tab includes resilient projections 142 extending radially inwardly over hole 136 at the opening of the hole on the first surface 132. Projections 142 are arranged in a similar pattern as those discussed above, and connected to a ring-like region of the contact tab 138 encircling the hole 136. In this embodiment, however, the projections 142 extend downwardly, into the hole 136, from the first surface 132 toward the second surface 134, so that the tip of each projection is recessed below the first surface. Thus, although each projection is substantially laminar, the projections 142 cooperatively define a conical lead-in or funnel-shaped structure at each hole. These structures aid in alignment of the microelectronic component with the connector during assembly; the bump leads tend to move towards the center of the funnel-shaped structures and thus towards the centers of the holes. Projections 142 typically are formed as portions of a flat sheet with ring regions 138 and with the other parts of the contact tabs, whereupon the projections of the resilient contact are permanently and plastically deformed from their original flat condition to the condition illustrated in Fig. 8 by means of an embossing process.

Also, projections 142 include a base metal 147 and a bonding material 143 overlying the base metal. The base metal 147 desirably is a metal or alloy as discussed above with reference to the contact tabs. The bonding material 143 may be a solder, a solder paste, a low temperature eutectic bonding material, a solid state diffusion bonding material, a polymer/metal composite bonding material, or other heat-activatable bonding material. For example, a solder paste such as Koki RE4-95K, a 63%tin-37%lead solder with 20-50 micron size distribution in a no-clean flux is preferred for bonding to a eutectic solder bump. Polymer/metal bonding material may include a dispersion of a metal such as silver or gold particles in a thermoplastic polymer such as Ultem_ material or thermosetting polymer such as an epoxy. Diffusion bonding materials may include layered structures of gold on nickel; alloys of gold and tin such as 80% gold, 20% tin; and alloys of tin and silver such as 5% silver, 95% tin. Solders may include alloys such as tin-lead and tin-indium-silver. Eutectic bonding materials may be selected from the group consisting of alloys of gold-tin, gold-germanium, gold-silicon or combinations of these metals, the gold-tin alloys being preferred. As is well known in the art, each type of bonding material normally is employed to bond structures compatible with the bonding material. For example, eutectic bonding materials and diffusion bonding materials are employed with contact base metal layers and with mating bump leads of metals such as gold adapted to form alloys with the bonding material. In this arrangement, there is no need for the bump leads on the components to have a bonding material.

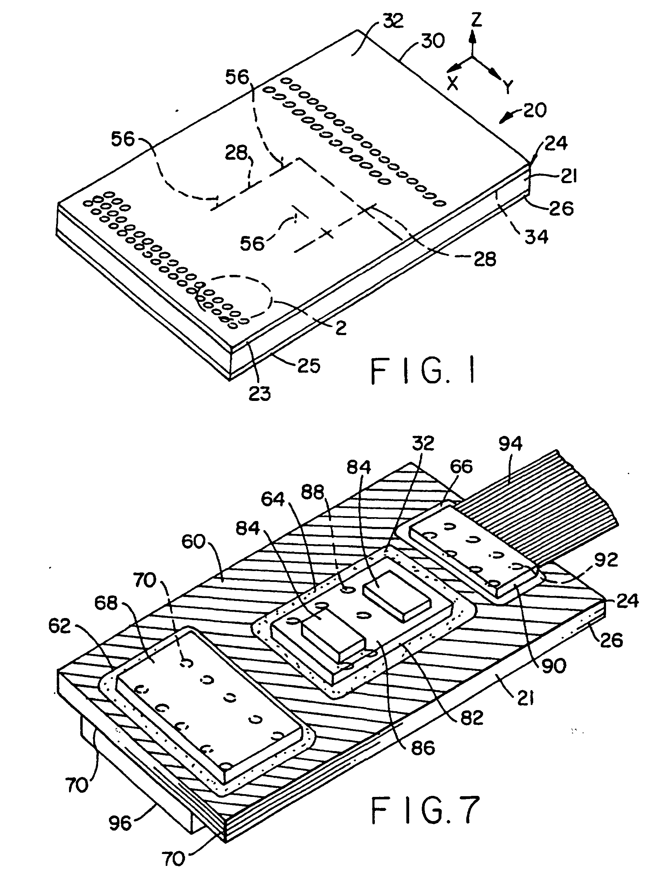

This connector further includes a layer 177 of a heat-activatable adhesive of the type commonly referred to as a "snap-cure" adhesive, on first surface 132. When the assembly is heated to activate the bonding material 143 on the contact, adhesive 177 bonds the chip or component to the mounting assembly to form a void-free interface. Moreover, the adhesive forms a seal around each contact and hole, so as to isolate the interiors of the holes and the interfaces between the bump leads and the contacts from contaminants in the environment. One suitable snap-cure adhesive is sold under the trademark ABLEBOND by the Ablestik Electronic Materials & Adhesives Company of Rancho Dominguez, California. Alternatively, a thermoplastic layer 177 may be used on the first surface 137 of the sheet socket as an adhesive for bonding the chip to the socket, where the chip can be removed from the socket by heating and reflowing the thermoplastic material. A preferred thermoplastic material for this reworkable adhesive layer is polyimide-siloxane. In other respects, the connector of Fig. 8 is used in the same manner as the components discussed above with reference to Figs. 1-7.

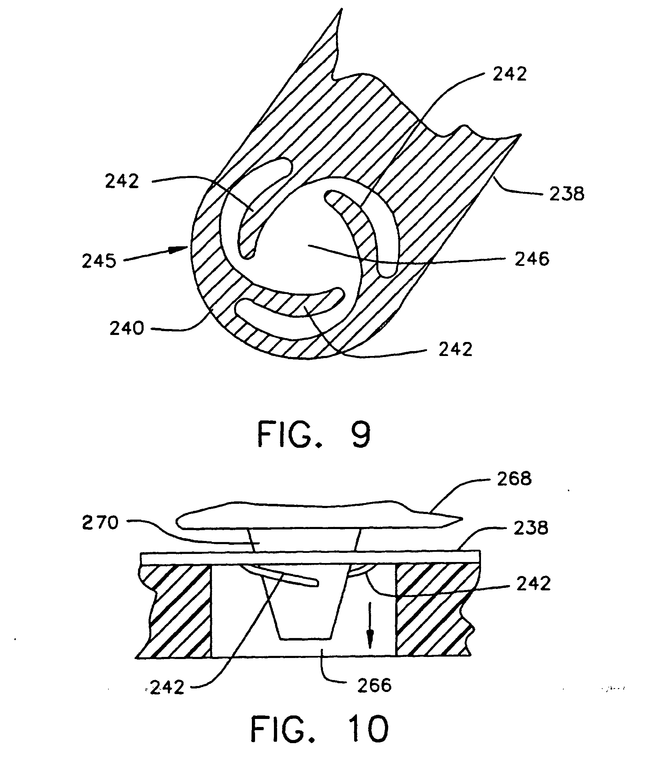

As illustrated in Fig. 9, a metallic contact tab 238 may have an active connector portion 245 including a ring-like region 240 encircling a central opening 246. Projections 242 spiral inwardly from the ring-like portion toward the center of this opening. In this embodiment, however, the projections do not extend directly radially inwardly, but instead extend both radially inwardly and circumferentially around the center of opening 246. Such projections provide substantial radial compliance. That is, projections 242 can deflect in directions transverse to their lengths and thus can move radially outwardly.

As illustrated in Fig. 10, a connector of the type depicted in Fig. 9 is being engaged with a microelectronic element or semiconductor chip 268. The bump leads 270 of chip 268 are not spherical as in the embodiments discussed above, but rather are truncated, conical structures. As each such bump lead enters into the opening 246 and moves downwardly into the hole 236 in the connector body, the circumferential surface of the bump lead is engaged and scraped by the projections 242 of the contact. Here again, either the contacts or the bump leads, or both, may be provided with bonding materials.

As illustrated in Fig. 11, a contact tab 338 may have a ring-like structure 340 defining a non-circular opening, and may have only a single projection 342 extending into that opening from one side thereof. This structure may be disposed asymmetrically with the associated opening 336 in the connector dielectric body so that a bump lead 370 entering into the hole 336 will become trapped between projection 342 and the side wall of the hole.

A contact according to yet another embodiment of the invention is schematically illustrated in Figs. 12 and 13. The contact body 438 again has a ring-like structure 440 defining an opening 446. In this structure, however, the structure includes a laminar substantially planar bridge structure 444 extending between two points 448 and 450 on opposite sides of the opening. Bridge structure 440 in turn includes a first resilient laminar spiral 452 extending from point 442 to a central point 454 and a second resilient laminar spiral 456 extending from point 450 to central point 454. Spirals 452 and 456 are of the same hand, and are intermeshed with one another. As illustrated in Fig. 13, the spirals can deflect downwardly upon application of a force F by a bump lead. Each of the spirals acts essentially as a coil spring. Moreover, the deformed spirals wrap around the sides of the bump lead 470, and wipe the surface of the bump lead. This arrangement provides the ability to resiliently engage a wide range of contact sizes.

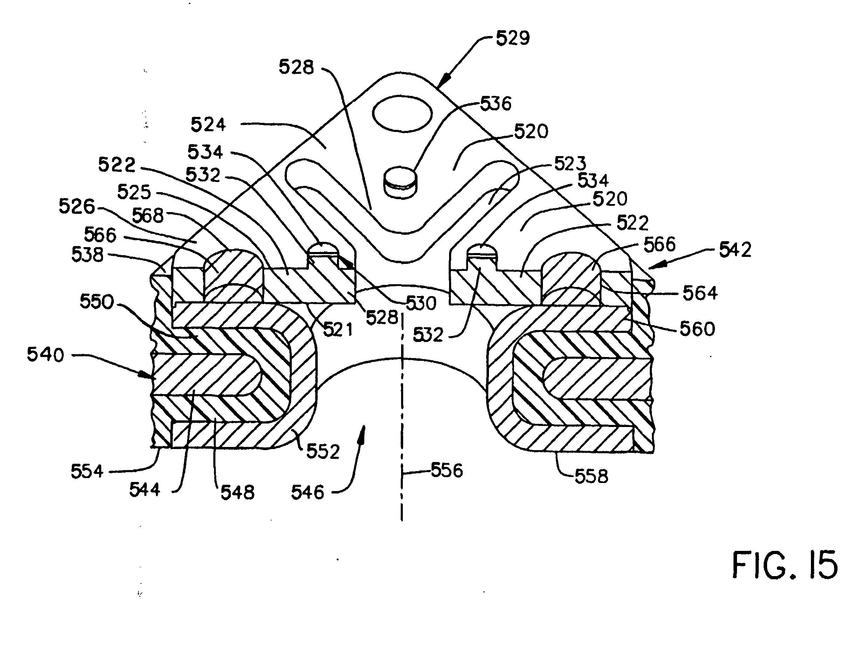

A connector according to one embodiment of the invention includes a plurality of independent, electrical contact units 529. Each contact unit includes four contacts 520. Each contact 520 includes a small metallic tab incorporating a base layer 522 (Fig. 15) defining an upwardly facing base surface 524. The base portion of each contact desirably is formed from a resilient metal selected from the group consisting of copper, copper-bearing alloys, stainless steel and nickel. Beryllium copper is particularly preferred. The base portion desirably may be between about 10 and about 25 microns thick. A layer 525 of an etch metal such as nickel used in the contact formation process as further described below may be disposed on base surface 524. Layer 525 desirably is between about 0.5 and 2.0 microns thick. Each such tab is joined to a generally square, ring-like anchor portion 526 integral with the tab. Each tab has a tip 528 at the end of the tab remote from the anchor portion.

Four tabs extend inwardly from each anchor portion 526, the tabs being separated from one another by channels 523. Each contact or tab 520 has an asperity 530 projecting upwardly from the base surface 524 adjacent the tip 528 of the tab. Each asperity includes a column 532 of a first or base metal integral with base portion 522 and further includes a cap 534 overlying the column 532 at the uppermost tip of the asperity, remote from base surface 524. Each column 532 is generally cylindrical or frustoconical in shape, so that the tip of each column is substantially circular. The cap of each column defines a flat, circular tip surface and substantially sharp edge 536 encircling the tip surface. Each asperity desirably protrudes upwardly from the base surface less than about 50 microns, more preferably between about 5 microns and about 40 microns, and most preferably between about 12 microns and about 25 microns. Each asperity may be between about 12 and about 50 microns in diameter, more preferably about 12 to about 35 microns in diameter. The cap metal 534 may be selected from the group consisting of metals resistant to etching by etchants which etch the first or base metal. Cap metals selected from the group consisting of gold, silver, platinum, palladium, osmium, rhenium and combinations thereof are preferred. As further discussed below, such etch-resistant metals aid in formation of sharp edges 536. Moreover, the harder etch-resistant metals, particularly osmium and rhenium, aid in preserving the edge during use.

The contact units are disposed on the top surface 538 of a connector body 540, and spaced apart from one another so that there are slots 542 between adjacent connector units. Connector body 540 incorporates a sheet-like, metallic element 544 having holes 546 therein. The metallic layer is covered by a bottom dielectric layer 548 and a top dielectric layer 550, which merge with one another within holes 546, so that the dielectric layer cooperatively lines the holes as well. A conductive metallic via liner 552 extends through each hole 546 from the top surface 538 of the connector body to the opposite, bottom surface 554. Each via liner 552 flares radially outwardly, away from the central axis 556 of the associated hole at the bottom surface so as to form an annular terminal 558 at such bottom surface. Each via liner also flares outwardly, away from the central axis at the top surface 538 so as to form a contact support structure 560. The periphery of each contact support is generally square.

Each contact unit 529 has four apertures 564 extending through the ring-like anchor portion 526, from its bottom surface 521 to the upwardly-facing base surface 524. One contact unit 529 is disposed on each contact support 560, substantially in alignment with the square boundary thereof. Each contact unit is secured to the associated contact support by four posts 566 integrally with the contact support 560 and extending upwardly through the hole 564 in the contact unit. Each post 566 has an outwardly protruding ridge or bulbous portion 568 at the end of the post remote from the contact support 560, overlying base surface 524. These posts and bulbous portion thus secure each contact unit 529 to the corresponding contact support 560 so that the individual contacts or tabs 520, and particularly the tips 528 thereof, protrude radially inwardly, toward the axis 556 of the associated hole 546 in the connector body so that tips of the contacts or tabs 520 overly the hole 546. The posts and the contact supports 560 also electrically connect each contact unit to the associated via liner and thus to the terminal 558 on the bottom surface.

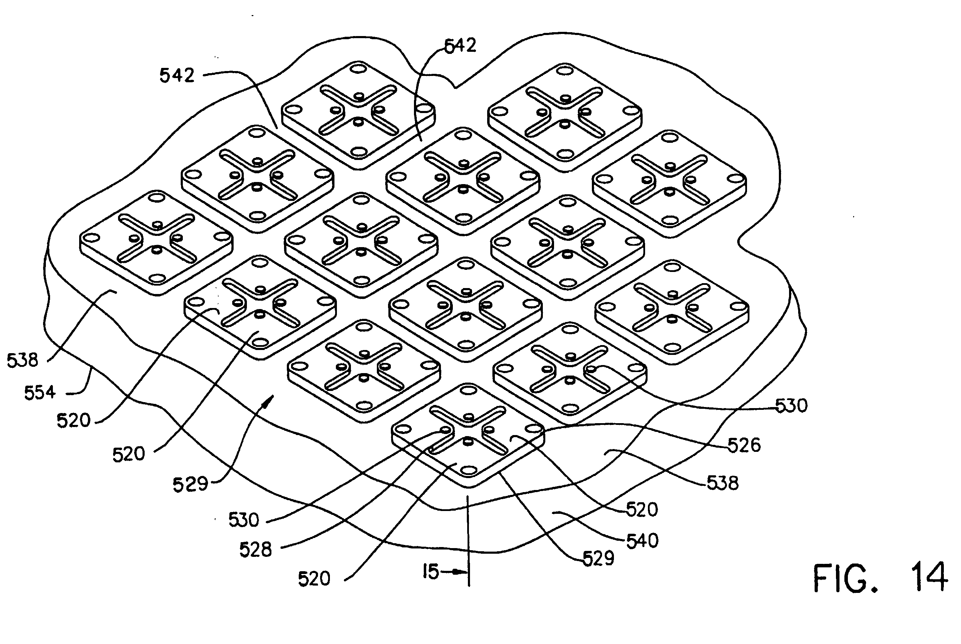

Contact units 529, and hence the individual contacts or tabs 520 are disposed in a regular pattern corresponding to the patterns of holes 546 in body 540. The asperities 530 on the contacts are also disposed in a regular pattern, in registration with the pattern of contacts 520, so that the same number of asperities are disposed on each contact. In the embodiment of Figs. 14 and 15, only one asperity is disposed on each contact. However, because both the asperities and the contacts are disposed in regular patterns, all of the contacts are provided with asperities. Also, the asperity on each contact is at the same location namely, adjacent the tip of the tab or contact, remote from the anchor region of the contact unit.

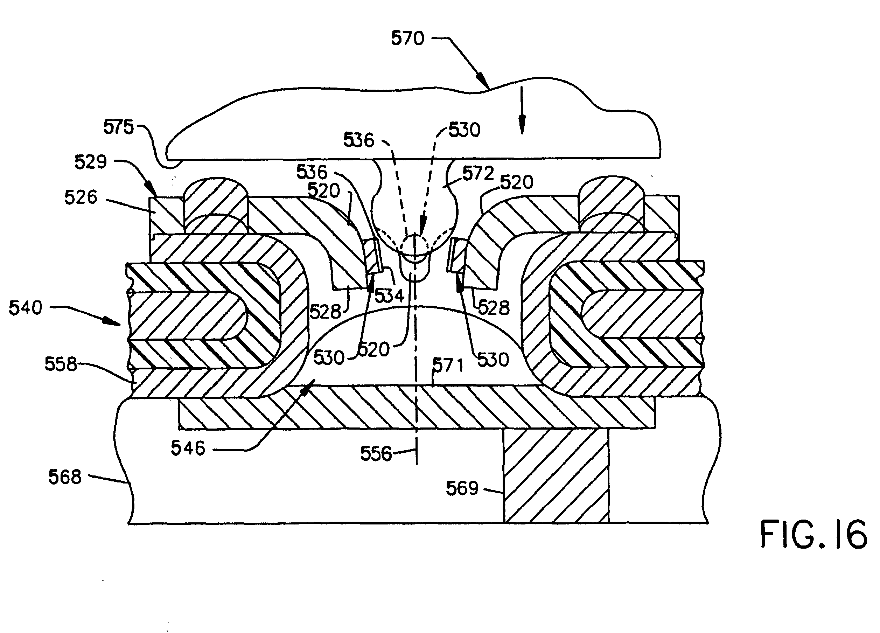

The connector of Figs. 14 and 15 may be engaged with a larger substrate, such as a multilayer substrate 568 having leads 569 therein. Each such lead having an exposed end 571 at the surface of the substrate. The terminals 558 of the connector, and thus the contact units 529, may be electrically connected to the internal leads 569 of the substrate by conventional lamination and/or solder bonding methods, or by the lamination and interconnection methods taught in International Patent Application 92/11395, the disclosure which is hereby incorporated by reference herein. After assembly to the substrate, the connector of Figs. 14 and 15 is engaged with a mating microelectronic element 570 so that a bump lead or solder ball 572 engages each contact unit 529. Thus, the mating microelectronic element 570 has bump leads 572 in a pattern corresponding to the pattern of holes 546 and contact units 529. Microelectronic element 570 is juxtaposed with the connector so that one bump lead or solder ball 572 is aligned with each contact unit and with the underlying hole 546 in the connector body 540. The microelectronic element is then forced downwardly, towards the connector body and towards the contact units 529 and individual tabs or contacts 520. This downward motion brings each such ball 572 into engagement with all four contacts or tabs 520 of the contact unit 529 and, in particular, engages the ball 572 with the asperities 530. As illustrated in Fig. 16, the anchor portion or outer periphery 526 of each contact unit remains substantially in fixed position, whereas the distal regions of each tab 520, adjacent the tips 528 of the tabs, bend downwardly, in the direction of motion of the engaged ball 572. In this condition, a part of each sharp edge 536 faces upwardly, in the direction opposite to the downward motion of microelectronic element 570 and ball 572. Each asperity is biased inwardly, towards the central axis 556 of the hole, by the resilience of the tab 520. The upwardly facing portion of each edge 536 tends to dig into the surface of ball 572 and scrapes the surface of the ball as the ball moves downwardly, into hole 546. The sharp-edged asperity on each tab thus scrapes a path along the ball or bump lead 572.

This scraping action effectively removes oxides and other contaminants from the scraped paths. This assures reliable electrical contact between contacts 520 and the balls or leads 572. In particular, the tips of the asperities aid in making contact with the balls or leads 572. Because the cap metal in layer 534 on the tip of each asperity is a substantially oxidation resistant metal, it normally does not have any substantial oxide or contaminant layer. Thus, the ball and contacts form a firm, reliable electrical interconnection. This action is repeated at each contact unit and with each ball or lead 572 on the surface of the microelectronic element, so that reliable interconnections are formed simultaneously between all of the balls or leads and all of the internal conductors 569 of substrate 568. These connections can serve as the permanent or semi-permanent interconnections of the assembly. Alternatively, the electrical connection achieved by mechanical interengagement of the element may be used as a test connection, so that microelectronic element 570, its connections to substrate 568 and the other elements connected to the same substrate can be tested and operated under power. If a defective connection or component is identified during the test, the same can be removed and replaced readily. Ordinarily, the connector and contacts can be reused. If only a temporary connection is desired, a stop element (not shown) may be interposed between the microelectronic element 570 and the connector, to limit the travel of the microelectronic element. Thus, the contacts will be only elastically deformed, rather than permanently bent. The connector can be reused repeatedly as a test socket.

After completion of the test, the assembly can be permanently bonded together. Each of bump leads 572 incorporates an electrically conductive bonding material compatible with the materials of contacts 520. Alternatively or additionally, the contacts themselves may carry conductive bonding materials. Various bonding materials known to those skilled in the art of microelectronic assemblies can be used for these purposes. For example, the bump leads 572 may be formed entirely from a solder or from a solder layer overlying an interior core (not shown). In this case, the electrically conductive bonding material or solder can be activated by heating the assembly causing the solder to flow. A flux such as a so-called "no-clean" flux can be provided either on the microelectronic element around the solder ball or on contacts 520. Alternatively, a solder paste such as Koki RE4-95K, a 63% tin - 37% lead solder in 20-50 micron diameter particles distributed in a no-clean flux can be provided on either the contact units or the balls or leads 572.

Bonding materials other than solder can also be employed, including a low temperature eutectic bonding material, a solid state diffusion bonding material, a polymer-metal composite bonding material or another heat-activatable bonding material. Thus, polymer-metal bonding materials may include a dispersion of a metal such as silver or gold particles in a thermoplastic polymer such as ULTEM material or a thermosetting polymer such as an epoxy. Diffusion bonding materials may include layered structures of gold on nickel; alloys of gold and tin such as 80% gold, 20% tin and alloys of tin and silver such as 5% silver, 95% tin. Solders may include alloys such as tin-lead and tin-indium-silver. High-temperature bonding materials may be selected from the group consisting of alloys of gold and tin; gold and germanium; gold and silicon or combinations thereof, the gold and tin alloys being preferred. In accordance with known principles, each type of bonding material normally is employed to bond structures compatible with that bonding material. For example, high-temperature bonding materials and diffusion bonding materials are employed with contact metals and bump lead or ball metals such as gold adapted to form alloys with the bonding material. The bonding material may be carried either on the contact units 529 or on the mating electrical elements or leads 572. The cap metal carried on the tip surfaces of the asperities may constitute the bonding material.

This structure provides a low inductance connection between the contacts 520 and the terminals 558. In this arrangement, there is no need for conductive vias separate from the bump-lead receiving holes. Instead, the holes 546 provide room for the through conductors or liners. Stated another way, the holes serve both to receive the bump leads of the microelectronic component and also to carry the conductors through the connector body. This allows for a very compact arrangement. The pitch or spacing between adjacent holes and contacts can be just slightly larger than the maximum diameters of the holes themselves and only slightly larger than the diameters of the bump leads to be received within the holes. Thus, the pitch may be about three times the bump lead diameter or less, and desirably as low as about twice the bump lead diameter. Suitable dimensions for various pitches are given in Table I below. In the table, bump lead diameter refers to the diameter of a ball-shaped bump lead on the microelectronic element. Maximum hole diameter refers to the diameter of the hole in body 540 at the first surface 538. Slot diameter refers to the dimension between opposite arcuate edges 523 of the slots, whereas the dielectric layer thickness refers to the thickness of the dielectric layer 550 and the contact refers to the thickness of the metal layer constituting the contacts and the projections 522.

**TABLE I**

| | (mm) | (mm) | (mm) |
|---|---|---|---|
| Pitch | 0.5 | 1.0 | 1.5 |
| Bump Diameter | 0.25 | 0.4 | 0.5 |
| Hole Diameter | 0.35 | 0.6 | 0.7 |
| Slot Dimension | 0.45 | 0.9 | 1.4 |
| Dielectric Thickness | 0.04 | 0.04 | 0.04 |
| Contact Thickness | 0.025 | 0.025 | 0.025 |

Because the apertures 564 and posts 566 are disposed adjacent the corners of each square ring-like contact, remote from the center of the associated hole, the posts and apertures are remote from the tabs or projections 520 and slots 523, i.e., remote from the active area of the contact. The posts and apertures do not interfere with the flexing action of the projections. However, because each attachment post 566 is disposed in alignment with one projection or tab 520, the attachment posts are ideally situated to resist stress placed on the joint between the contact and the connector body. Here again, the laminar, ring-like contacts are substantially square and substantially fill the top surface of the connector, with only small gaps therebetween to provide electrical isolation.

The connector may also have a dielectric adhesive disposed on the second or bottom surface of the connector body, in the regions between the terminals 558. The dielectric adhesive may be, for example, a snap-cure adhesive as discussed previously. The terminals 558 may be covered with a heat activated conductive bonding material similar to those discussed above, for connection to leads of the substrate.

In a variant of the embodiment shown in Figs. 14-16, the attachment to the contact support may be provided as raised features surrounding the periphery of the contact ring. For example, ribs (not shown) may project upwardly along side the edges of the individual contacts, and may have projecting sections extending inwardly so as to thereby overlap the edges of each contact.

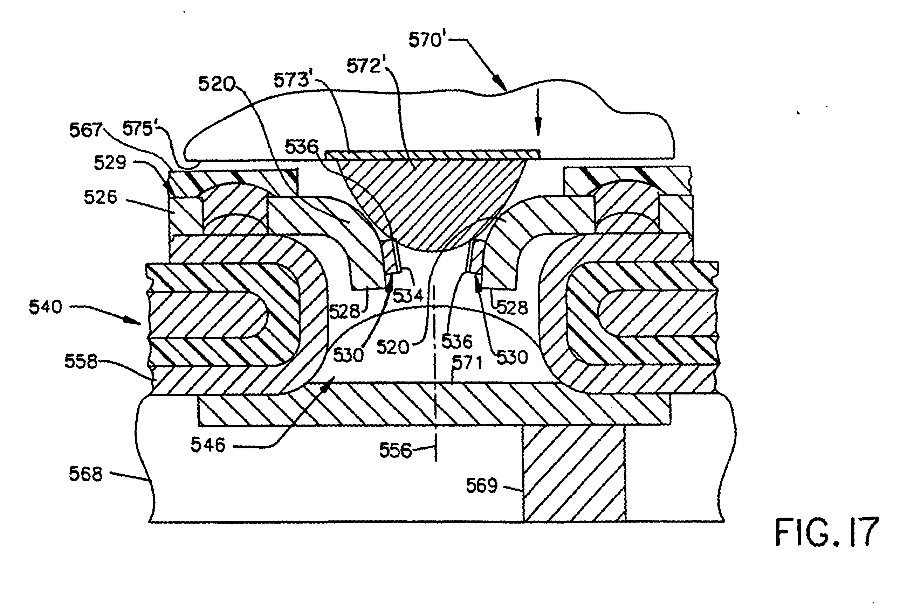

A connector according to a further embodiment of the invention is substantially identical to the connector of Figs. 14-16, but includes a layer of a conventional photographically patternable solder mask material 567, (Fig. 17) covering the top surfaces of the connector body and contact unit. Solder mask layer 567 is provided with holes aligned with the holes 546 in the connector body and with the central axes 556 of the holes and contact units. The tips or distal ends 528 of the contact tabs are exposed within the holes 565 of the solder mask layer, whereas the square ring-like anchor portions 526 of the contact units, and the proximal ends of the tabs adjacent the anchor portions are covered by the solder mask layer. The solder mask layer may be formed from photoimagable polymers or from other polymers such as epoxies and polyimide. Thermoplastic materials such as polyetherimide (available under the registered trademark Ultem) and fluorocarbons, particularly fluorinated ethylene-propylene ("FEP") may also be used.

The connector of Fig. 17 may be engaged with a larger substrate, such as a multilayer substrate 568 having leads 569. The terminals 558 of the connector, and thus the contact units 529, may be electrically connected to the internal leads 569 of the substrate by conventional lamination and/or solder bonding methods, or by the lamination and interconnection methods taught in United States Patent 5,282,312, the disclosure which is hereby incorporated by reference herein.

After assembly to the substrate, the connector of Fig. 17 is engaged with a mating microelectronic element 570'. Microelectronic element 570' may be an active microelectronic device such as a semiconductor chip, or may be a circuit-bearing substrate or panel or other device. The microelectronic element has a body having a rear surface 575' with terminals 573' thereon connected to other electronic circuitry or components of the microelectronic element (not shown). Terminals 573' are disposed in an array matching the array of contact units 529 and holes 546 on the connector. A mass of a heat-softenable bonding material such as solder 572' is disposed on each terminal 573'. The solder masses are in the form of bumps protruding upwardly from surface 575. The solder masses desirably include one or more metals selected from the group consisting of lead, tin, silver, indium and bismuth. Lead-tin alloys; lead-tin-silver alloys; or indium-bismuth alloys may be used.

In an assembly process according to one embodiment of the invention, the rear surface 575' of microelectronic element 570' is placed adjacent the front surface of the connector body 540. The terminals 573' and solder masses 572' on the microelectronic element are aligned with the holes 546 in the connector body and hence with the central axes 556 of the contact units and holes. During this stage of the process, the solder masses are at a temperature substantially below the melting temperature of the solder and therefore are in a substantially solid, rigid condition. The surface of each solder mass bears on the tabs of the associated contact unit adjacent the tip or distal end of the tab. At least during some portions of this engagement step, the solder units engage each tab by means of the asperity 530 on the tab. The microelectronic element is then forcibly engaged with the connector by forcing the microelectronic element toward the top surface of the connector body. As illustrated in Fig. 17, the anchor portion or periphery 526 of each contact unit remains substantially in fixed position, whereas the distal regions of each tab 520, adjacent the tips 528 of the tabs, bend downwardly, in the direction of motion of the engaged solder mass 572. In this condition, a part of each sharp edge 536 faces upwardly, in the direction opposite to the downward motion of microelectronic element 570' and solder masses 572'. The tip 528 of each tab, and the asperity on such tip are biased inwardly, towards the central axis 556 of the hole, by the resilience of the tab 520. The upwardly facing portion of each edge 536 tends to dig into the surface of a solder mass 572'. The sharp-edged asperity on each tab thus scrapes a path along the surface of the solder mass 572'.

This scraping action effectively removes oxides and other contaminants from the scraped paths. This assures reliable electrical contact between contacts 520 and the solder masses 572'. In particular, the tips of the asperities aid in making contact with the solder masses 572'. Because the cap metal in layer 534 on the tip of each asperity is a substantially oxidation resistant metal, it normally does not have any substantial oxide or contaminant layer. Thus, the solder masses and contacts form a firm, reliable electrical interconnection. This action is repeated at each contact unit and with each solder mass 572' on the surface of the microelectronic element, so that reliable interconnections are formed simultaneously between all of the solder masses 572' and all of the internal conductors 569 of substrate 568. The electrical connection achieved by mechanical interengagement of the element may be used as a test connection, so that microelectronic element 570', its connections to substrate 568 and the other elements connected to the same substrate can be tested and operated under power. This test also serves to test electrical continuity between the solder masses 572' and contacts 520. If a defective connection or component is identified during the test, the same can be removed and replaced readily. Ordinarily, the connector and contacts can be reused.

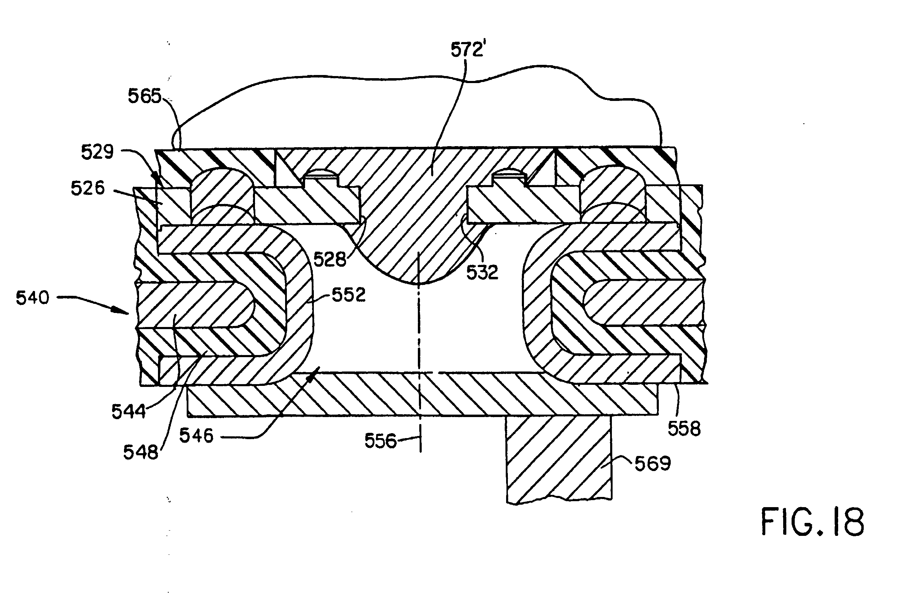

Following completion of the testing step, the engaged solder masses and contacts are heated to an elevated bonding temperature sufficient to soften the solder. Preferably, this heating is accomplished without disengaging the solder masses from the contacts. The solder masses remain in engagement with the contacts from completion of the testing step throughout the remainder of the process. The bonding temperature is sufficient to soften the solder, as by converting some or all of the solder to a liquid phase. The solder masses and contacts may be heated by exposing the entire assembly to any suitable heating medium, such as a hot gas, radiant energy or the like. As the solder softens, each tab 520 springs back from the deformed condition of Fig. 17 towards its original, undeformed shape. As shown in Fig. 18, the distal ends or tips of the tabs penetrate into the solder mass. Although the present invention is not limited by any theory of operation, it is believed that the wiping action between the contacts and the surface of the solder mass during the engagement step, and particularly, the scraping action of the asperities on the contacts facilitates penetration of the solder mass surface by the contacts. It is believed that disruption of the oxide layer during the wiping and scraping action materially reduces the coherence of the oxide layer after softening of the solder masses. This in turn allows the contact tips to break through the oxide layer readily and to enter into the substantially pure, unoxidized solder beneath the oxide layer. The wiping action also tends to remove oxides or other contaminants from the surfaces of the contact tips.

Because the tips of the contacts are immersed in the pure, unoxidized solder, they are readily wetted by the solder. Provided that at least some portions of the contact tips are substantially free of oxidational or other impurities at this stage of the process, the pure solder can effectively wet the contact tips. No fluxes or other extraneous chemical agents are required. The assembly desirably is held at the elevated bonding temperature for a period sufficient to ensure that all parts of the assembly reach the bonding temperature. The contacts tend to recover and penetrate into the solder masses to substantially instantaneously after the solder masses soften. When the solder wets the contact tips, it tends to flow along the surfaces of the contacts under the influence of capillary action. This tends to draw the solder outwardly, away from the tips of the contacts and towards the anchor regions of the contacts. The solder mask layer 567 blocks such outward flow. Where the solder mask layer includes a material such as a thermoplastic material or other material which can be softened by heat, the solder mask may be brought to a flowable condition when the assembly is heated to the bonding temperature. The solder mask layer thus flows into conforming contact with the surface 575' of the microelectronic element and bonds to the surface. This forms a seal which encloses each contact and solder mass in an individual cavity, thus protecting the connections from the environment. Alternatively or additionally, the solder mask layer may include an adhesive, such as an acrylate adhesive, which bonds to surface 575'.

After the assembly has been heated to the bonding temperature, it is cooled to a temperature below the bonding temperature, typically to room temperature, so as to resolidify the solder. The resulting assembly includes solid solder masses 572' penetrated by the contact tabs 520 and metallurgically bonded to the contact tabs. Each solder mass protrudes generally in an axial or Z direction, generally perpendicular to the top surface of the connector body and generally parallel to the axis 556 of the associated hole 546 in the connector body. Thus, each solder mass extends axially through the center of one ring-like anchor region 526. The contact tabs associated with such tabs associated with such ring-like anchor region extend generally radially inwardly into the solder mass. This configuration provides a particularly strong bond. Most preferably, the array of contact tabs penetrating into each solder mass substantially surrounds the solder mass in all radial directions. Thus, movement of the solder masses relative to the contacts in any radial or X-Y direction tends to force the contact into even more intimate engagement with one or more of the contact tabs. Although the contact tabs are illustrated in Figure 18 as being fully restored to the original, undeformed condition, this is not essential. Thus, the contact tabs, after the softening and cooling steps, may have some residual deformation in the axial direction, into the hole, so that each contact tab slopes both axially and radially.

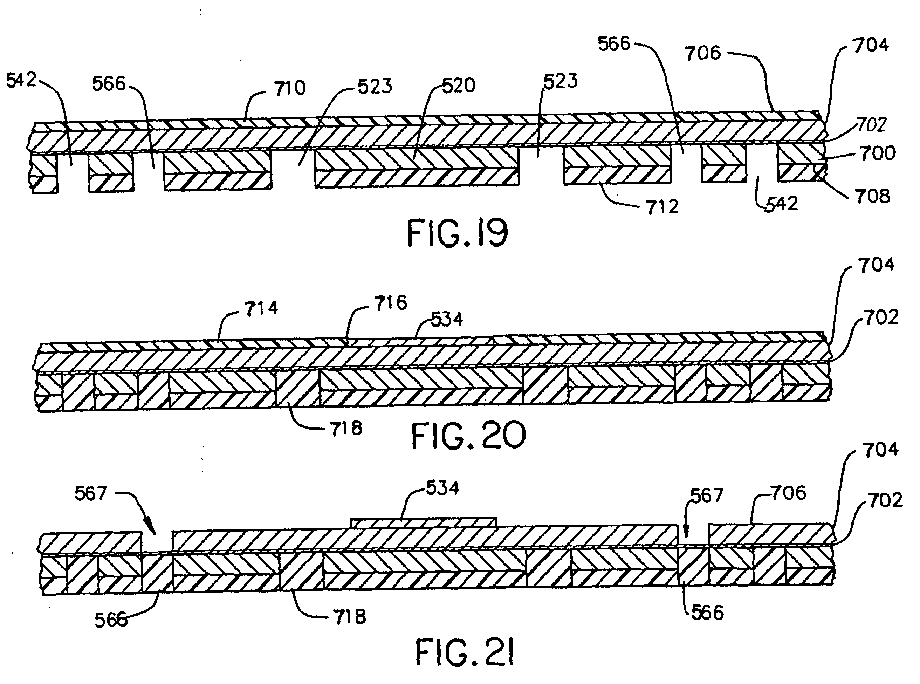

A fabrication process according to a further embodiment of the invention may be utilized to fabricate contact units and connectors as described above with reference to Figs. 14-18. The process begins with a sheet 700 of a base metal (Fig. 19), covered with a thin layer 702 of an etch-stop metal and a further layer 704 of the base metal overlying the etch-stop metal. Thus, sheet 704 defines the top surface 706 of the composite, three-layer sheet whereas sheet 700 defines the opposite, bottom surface 708. The thickness of layer 704 corresponds to the desired height of the base metal column 532 in each asperity 530 (Fig. 15) whereas the thickness of bottom layer 700 corresponds to the desired thickness of the base metal layer 522 constituting each contact tab. In a bottom surface etching step, the top surface is protected by a continuous mask 710, whereas the bottom surface is covered by a layer 712 of a conventional photoresist. The photoresist is patterned using conventional photoexposure and selective removal techniques, so as to leave gaps in the resist. The sheet is then subjected to etching by emerging in an etch solution such as a solution of CuCl, NH₄OH and NH₄Cl. The etch solution attacks the copper-based alloy of lower layer 700 but does not substantially attack the stop layer 702. The patterning of resist 712 is controlled so that the exposed, etched areas include channels 523 in base metal layer 700 bounding tabs 520, as well as apertures 566 in the anchor regions and slots 542 bounding the anchor regions and subdividing lower layer 700 into individual portions corresponding to the separate contact units discussed above.

In the next stage, top coating 710 is removed and replaced by a top pattern resist 714 (Fig. 20), which again is patterned using conventional photographic methods to leave openings 716 corresponding to the locations of the asperities 530. Thus, each opening 716 is substantially in the form of a circular hole corresponding to the circular asperity. The features on the bottom surface are covered by a further bottom resist 718, and then the assembly is electroplated with the cap metal 534. At this stage of the process, top base metal layer 704 and stop layer 702 are still solid and continuous. Although only a small portion of the sheet is illustrated, corresponding to portions of one contact unit, it should be appreciated that the sheet includes numerous contact areas, sufficient to form one or more complete connectors. Stop layer 702 and top layer 704 remain continuous and coherent and all portions of the sheet are electrically continuous with one another at this stage.

Following application of the cap metal, top surface holes 567 are formed in alignment with the apertures 566 previously formed in the bottom surface. These top surface holes extend through top base metal layer 704 and extend through stop layer 702. Top surface holes 567 may be formed by applying radiant energy to the top surface 706 of the sheet in a pattern corresponding to the desired pattern of aperture 566 or by etching the top surface using a further patterned mask (not shown). Such an etching process desirably uses a CuCl NH₄OH and NH₄Cl etch solution to etch from the top surface to top layer 102, followed by a further etch using an FeCl and HCl etch solution to etch through stop layer 702. Following this procedure, any mask used in forming top holes 567 is removed, and the bottom masking 718 is also removed.

In this condition, the sheet is laminated to a connector body 540 having the structure discussed above, with pre-existing holes, via liners 552 and contact supports 560. The connector body may be fabricated by etching the metal layer 544 to form holes, then applying a conformal coating on the etched metal by processes such as electrophoretic coating of a dielectric film such as epoxy or poly-methyl methacrylate to form dielectric layer 550. Dielectric layer 550 may be on the order of 0.02-0.06 mm and preferably about 0.04 mm thick. The via liners 552 and contact supports are formed by plating over the dielectric layer. At this stage of the process however, the posts 566 and bulbous portion 568 have not yet been formed.

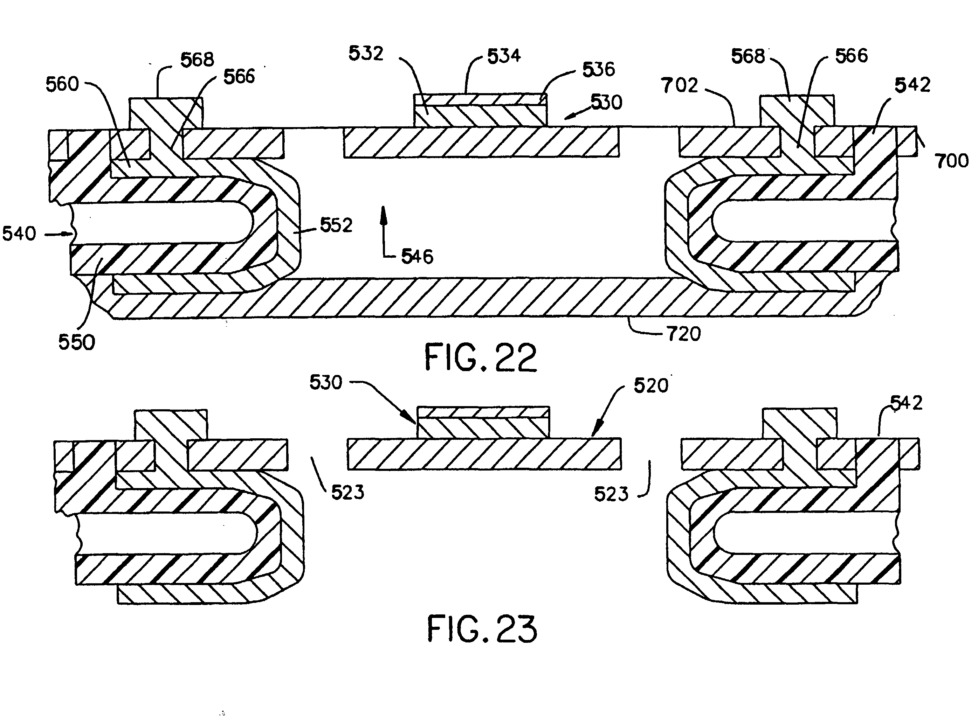

The lamination procedure is conducted so as to align each region which will ultimately become a contact unit 529 with the corresponding hole 546 and with the corresponding contact support 560. The dielectric material on the top surface of the connector body desirably softens and penetrates into the slots 542 between adjacent connector units. In the next stage of the process, the bottom surface of connector body 540 is covered with a masking layer 720 (Fig. 22), thus protecting the bottom surface of base metal layer 700. The assembly is then immersed in a further etching solution, such as a CuCl and HCl etching solution which attacks the base metal. This further etch solution removes the base metal of top layer 704 everywhere except at the spots covered by cap layers 534. This etching procedure thus forms base metal columns 532 extending upwardly from the base metal layer 700 and upwardly from the stop metal layer 702. The etch procedure thus forms asperities 530 in the areas covered by cap layers 534. This etching procedure also leaves each asperity with a sharp edge 536 defined by the cap layer and surrounding the tip of the asperity.

Following this etch procedure, a further masking layer (not shown) is applied on the stop layer 702 and on the other upwardly facing features, leaving holes only in alignment with apertures 566. The assembly is then electroplated with a metal compatible with contact supports 560, such as copper, thereby forming post 566 and outwardly extending or bulbous tips 568. Following this procedure, the mask used is removed and a further mask is applied and photodeveloped to leave a pattern of openings corresponding to the desired pattern of channels 523 and slots 542. A further etch solution, capable of attacking stop layer 702, such as an FeCl/HCl solution, is applied and allowed to attack the stop layer in the open areas of the mask until the etch solution breaks through stop layer 702 at slots 542, thereby subdividing the original coherent metallic sheet into individual contact units. The etch also breaks through at channels 523, thereby converting individual portions of each contact unit into individual contacts or tabs 520 in the configuration discussed above. The bottom mask is then removed, leaving the connector in the configuration discussed above with reference to Figs. 14-18.

During the process discussed above, the sheet remains physically coherent and electrically conductive until the last etching phase, so that the sheet can be successfully mounted on the connector body and successfully electroplated to form the posts. Each of the individual steps of the process requires only conventional masking and etching techniques. Because the asperities are performed in the same series of process steps as used to form the contacts and contact units, the asperity pattern can be provided in good registration with the contact pattern.

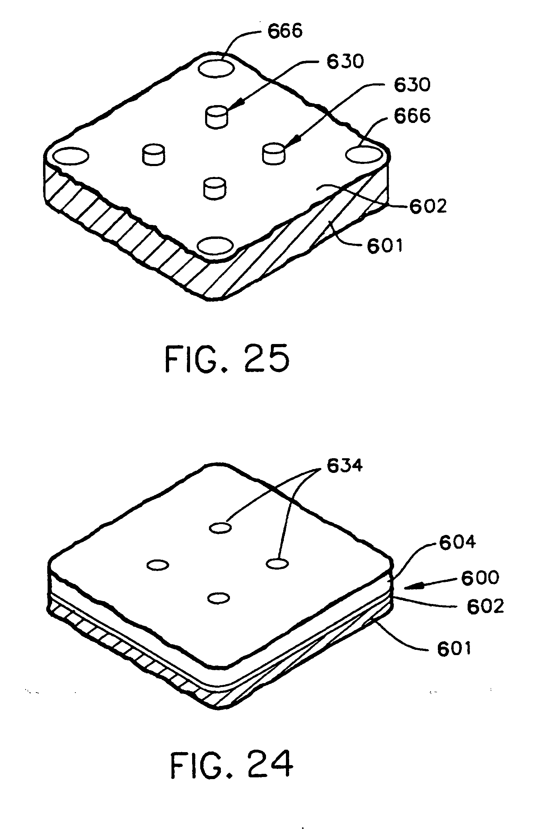

A process according to a further embodiment of the present invention begins with a composite sheet 600 (Fig. 24) incorporating a top base metal layer 604 and stop layer 602 similar to those discussed above over a bottom layer 601 formed from a flexible but resilient polymeric material, desirably a polyimide. Top layer 604 has a thickness approximately equal to the desired height of the asperities, typically about 5 microns to about 25 microns, and may be formed from a readily etchable metal such as copper or a copper based alloy. Stop layer 602 includes a material, such as nickel, which resists etchants that attack top layer 604. Stop layer 602 may be a composite layer, incorporating a sublayer about 0.5 microns to about 2.0 microns of the etch resistant metal over another sublayer of copper or other metal less than about 10 microns thick. The bottom polyimide layer desirably is about 10 microns to about 50 microns thick. In the process, an etch resistant material such as a photoresist is applied in a pattern of spots 634 corresponding to the desired pattern of asperities. Here again, although only a few asperities adapted to form parts of a single contact unit are illustrated, the actual sheet encompasses a relatively large area, corresponding to many contact units. The sheet is then subjected to an etching process using an etchant which attacks the top layer 604 but which does not attack either the stop layer 602 or the bottom layer 601 as, for example, CuCl/HCl solution. This leaves asperities 630 (Fig. 25) protruding upwardly from stop layer 602, in a pattern corresponding to the pattern of etch resistant spots 634, and leaves stop layer 602 as a continuous electrically conductive layer. The resist constituting spots 634 is then removed and a further resist is applied with open areas corresponding to apertures 666. While this resist is in place, the assembly is subjected to a further etching process, thus removing stop or conductive layer 602 in the areas corresponding to apertures 666. After removal of the stop layer in these areas, the assembly is subjected to laser ablation using a KrF excimer laser, or using other suitable radiation which is strongly absorbed by the polymer of bottom layer 601. This extends apertures 666 entirely through bottom layer 601. In this condition, the sheet is still coherent and electrically conductive over its entire area.

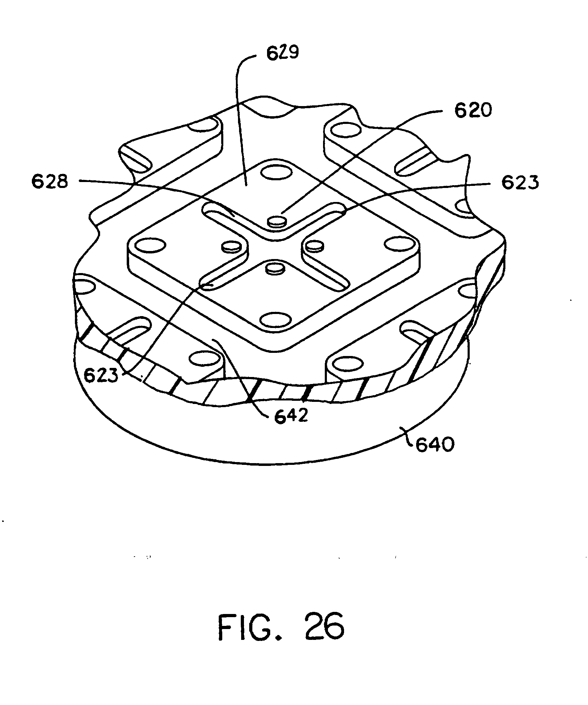

The sheet is then laminated to a connector body 640 (Fig. 26) in the essentially the same manner as discussed above with reference to Fig. 22. Thus, the sheet is aligned with the connector body so that each zone of the sheet constituting an individual contact unit is aligned with the corresponding hole and contact support of the connector body. The sheet is laminated to the top surface of the connector body so as to physically secure the sheet to the connector body. In this operation, the polymeric material of bottom layer 601 desirably merges with the dielectric material of the connector body itself. Following this lamination operation, the assembly is electroplated to form posts extending through apertures 666. These posts merge with the contact supports of the connector body and with the stop layer 602 in substantially the same way as posts 566 described above with reference to Figs. 14-23. The posts provide electrical continuity through bottom layer 601, so that each zone of the stop or conductive layer 602 is electrically connected to the corresponding contact support and via liner (not shown) of the connector body.

In the next stage of the process, the stop layer is etched, using a conventional masking and etching procedure, to form channels 642 subdividing the stop layer into individual contact units 629 (Fig. 26). The stop layer is further etched to form channels 623 subdividing the stop layer within each contact unit into individual tabs or contacts 620. Following this etching procedure, the assembly is once again subjected to laser ablation in the areas corresponding to channels 623. During this laser ablation process, the surrounding regions of stop layer 602 serve as a mask, and precisely limit the laser ablation process to the channels 623. This laser ablation process removes the underlying portions of layer 601 leaving the individual tabs or contacts 620 disconnected from one another at their tips 628. Thus, the individual tabs of each contact unit 629 project inwardly over the associated hole (not shown) in the connector body, in substantially the same manner as discussed above with reference to Figs. 14 and 25.

The tabs or contacts formed by this process are composite; each tab incorporates a lower layer 601 formed from polymeric material, a relatively thin electrically conductive layer overlying that polymeric material and an asperity extending upwardly from the polymeric layer and conductive layer. Desirably, the conductive layer, formed from stop layer 602, is thinner than the polymeric layer. Thus, the conductive layer may be less than about 10 microns thick, desirably between about 0.5 micron and about 3 microns thick and more preferably between about 0.5 micron and about 2.0 microns thick. This construction makes it practical to provide relatively low spring constants, and to allow for substantial deformation of the tabs while maintaining relatively low stress levels in relatively short tabs. For example, each tab may be between about 100 and about 300 microns long, from the anchor region to the asperity. During use, each tab acts as a cantilever beam. Because the polymeric layer has a modulus of elasticity far lower than a metallic layer, the stiffness of the composite beam can be relatively low, and can be controlled accurately. As described above, the composite contacts most preferably are provided with asperities to provide the scraping action. However, the composite contacts provide significant advantages even where the scraping action provided by the asperities is not required. For example, in certain special bonding processes, such as gold-to-gold diffusion bonding conducted under conditions where both the contacts and the mating elements are maintained free of surface impurities, acceptable bonding can be achieved without the scraping action. Thus, a connector according to a further embodiment of the invention, for use in such a process, may include composite contacts with the polymeric layer and with the thin conductive layer, but without the asperities. Such a connector provides the advantage of well-controlled interengagement forces.

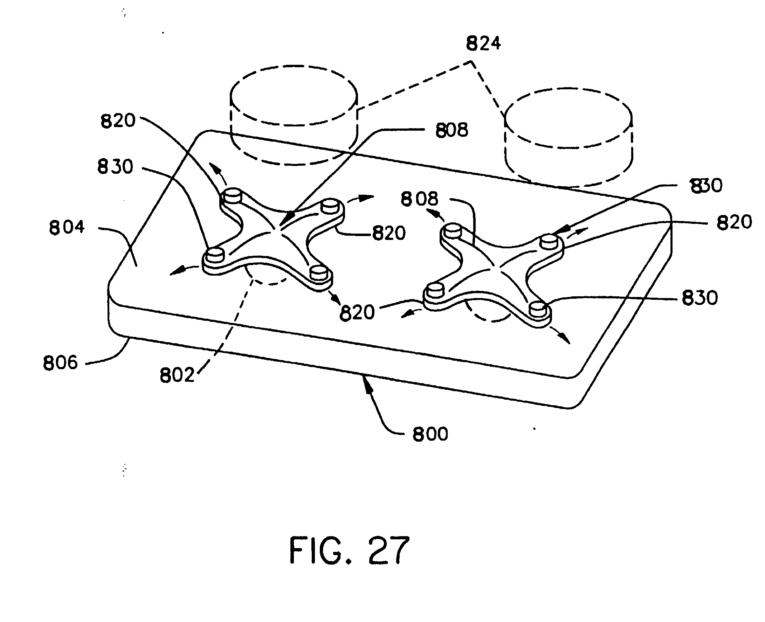

A connector in accordance with a further embodiment, of the present invention may include a connector body 800 (Fig. 27) and a plurality of conductors extending in the body as, for example, through conductors 802 extending between the top surface 804 and bottom surface 806 of the body. Contacts 808 may be connected to the conductors, and each contact may flare radially outwardly from the associated conductor. Each contact may be arranged so that the periphery of the contact will expand radially outwardly, away from the associated conductor, in response to a vertical force directed toward the body applied to the contact. Thus, each contact may include a plurality of tabs 820 arranged so that the tabs can be bent downwardly towards the body when the tabs are engaged with mating electrical elements such as contact pads 824 of a microelectronic device. The tabs may be spaced above the top surface 804 of the connector body, or the body may incorporate a material at the top surface which can be softened during assembly, to permit downward movement of the tabs.

In this embodiment of the present invention, sharp-featured asperities are provided on the contacts 808 at locations such that the outward expansion of the contacts will cause the asperities to scrape the mating contact pads 824. The asperities desirably have sharp edges 836 extending at least around the outwardly-facing portion of each asperity. These asperities may be formed by processes as described above.

A manufacturing process in accordance with a further embodiment of the invention begins with a sheet 902 of a first metal such as beryllium copper, phosphor bronze or the other resilient metals discussed above. A continuous protective layer 904 is applied on the bottom surface of the sheet. A photoresist is applied on the top surface and selectively exposed and developed to form numerous circular dots 906 on the top surface of the sheet. The dots are arranged in groups 908, each group occupying a square region corresponding to one contact unit. The regions are separated from one another by linear spaces 910 about 0.1 mm wide. The dots are about 12 to 35 microns in diameter. Within each group, the dots are spaced apart from one another at a pitch of about 30 to about 50 microns. Each group 908 includes about 28 dots, and occupies a region about 0.4 mm square, so that the groups are disposed in a recurring rectilinear array with a group-to-group pitch of 0.5 mm. In the next stage of the process, the sheet is etched, so as to form a base surface 911 and asperities 912 protruding upwardly from the base surface. After etching, the resist dots 906 are removed. The asperities are disposed in the same arrangement as dots 906, and disposed in asperity groups 914 corresponding to dot groups 908. Each asperity is generally fustoconical, and includes a circular tip surface 916 remote from the base surface 911. A substantially sharp, circular edge encircles each tip surface. In this embodiment, the tip surfaces and edges are defined by portions of the first metal corresponding to the original top surface of the sheet. The height of the asperities, and the distance between the base surface 911 and the bottom surface of the sheet, is controlled by the depth of etching. Etch depth, in turn, is controlled by known factors including concentration of the etch solution, time of exposure, temperature and agitation. These factors preferably are maintained substantially constant over the entire extent of the sheet.

In the next stage of the process, a cover layer 918 is applied over the top surface, so that the cover layer overlies the tips of the asperities. An adhesive 920 fills the spaces between asperities, including the linear spaces between asperity groups, and holds the cover layer to the sheet. The cover layer and adhesive may be provided in a prepared assemblage, such as the material available under the trademark COVERLAY from the E.I. DuPont Company. The bottom cover layer 904 is removed and replaced by a bottom photoresist 922. The bottom photoresist is selectively exposed and developed to form linear slots 926 aligned with the linear spaces between groups of asperities, the slot channels being narrower than the spaces. The bottom photoresist also includes channel openings 924 arranged in an X-shaped pattern beneath each asperity group. The sheet is then etched again, until the etch breaks through to base surface 911 on the top side of the sheet, so as to form slots 930 bounding each asperity group 914 and isolating each such asperity group from the others. The same etching step also forms channels 928 in an X-shaped pattern within each asperity group. This step thus subdivides the sheet into individual contact units corresponding to the individual asperity groups 914, and forms four contacts or tabs 932 within each such contact unit.

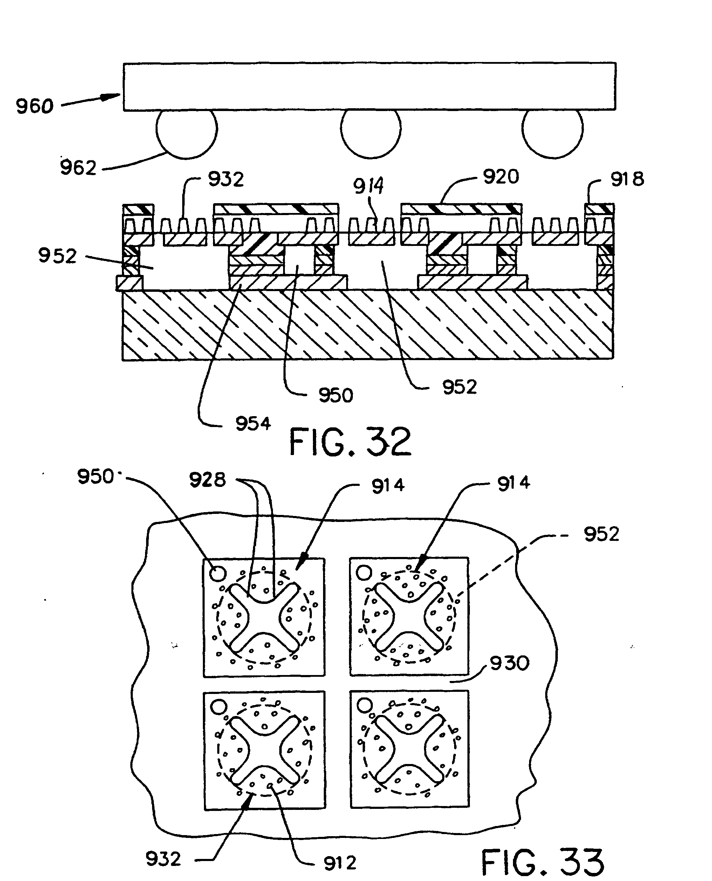

The registration between the asperity pattern on the top surface and the channel openings in the bottom photoresist is not precise. Some asperities 912a (Fig. 31) overlie the areas etched to form the channels. However, the spacing between asperities is small in comparison to the dimensions of the tabs 932, so that each tab includes at least one asperity.

In the next stage of the process, the bottom resist 922 is removed, leaving the assemblage of the etched sheet and cover layer. This assembly is then laminated to with an interposer 940 and a substrate 942. Interposer 940 includes a dielectric sheet 944 and flowable dielectric layers 946 and 948 on the top and bottom surfaces of such sheet. The interposer further includes conductors 950 formed from flowable conductive material extending through the dielectric sheet and flowable dielectric layers. The dielectric and conductive materials may be those used in the interposers described in United States Patent 5,282,312, the disclosure of which is hereby incorporated by reference herein. For example, the flowable dielectric may be an epoxy, whereas the flowable conductive material may include a polymer filled with metallic particles. The interposer has through holes 952 disposed in a rectilinear grid pattern corresponding to the pattern of contact units or asperity groups 914. Conductors 950 are disposed in a similar grid offset from the grid of holes. Substrate 942 includes contact pads 954 disposed in a similar grid, and internal circuitry (not shown) connected to the contact pads. The substrate may also include other elements (not shown) for connecting the internal circuitry to other devices.

In the lamination process, the assemblage of etched sheet and cover layer, interposer and substrate are aligned with one another so that the center of each contact unit (at the center of the X-shape defined by the channels 928) is aligned with a hole 952 of the interposer, whereas a conductor 950 of the interposer is aligned with a corner of the contact unit. Each conductor 950 is also aligned with a contact pad 954 of the substrate. The aligned elements are subjected to heat and pressure so as to activate the flowable dielectric and conductive materials and unite the sheet assemblage, interposer and substrate. The flowable material in each conductor 950 electrically connects the aligned contact unit 914 and contact pad 954. The flowable dielectric material on the top surface of the interposer fills slots 930, and merges with the adhesive 920 in the sheet assemblage.

The laminated assembly is then selectively exposed to radiant energy, such as laser light, directed from the top surface at the center of each contact unit. The radiant energy selectively ablates the cover layer 918 and adhesive 920 in the areas overlying the contacts or tabs 932 and channels 928, thus exposing these elements at the top surface of the assembly. By removing the surrounding adhesive and dielectric materials, the radiant energy will also remove any loose fragments of asperities left overlying the channels 928. However, the radiant energy does not substantially melt asperities on the contacts, or substantially dull their edges. The completed connector may now be used in substantially the same manner as the connectors discussed above. Thus, a microelectronic element 960 with bump leads 962 may be engaged with the completed connector so that the bump leads penetrate into holes 952 and engage contacts 952. Here again, the bump leads are engaged and scraped by the asperities on the contacts.

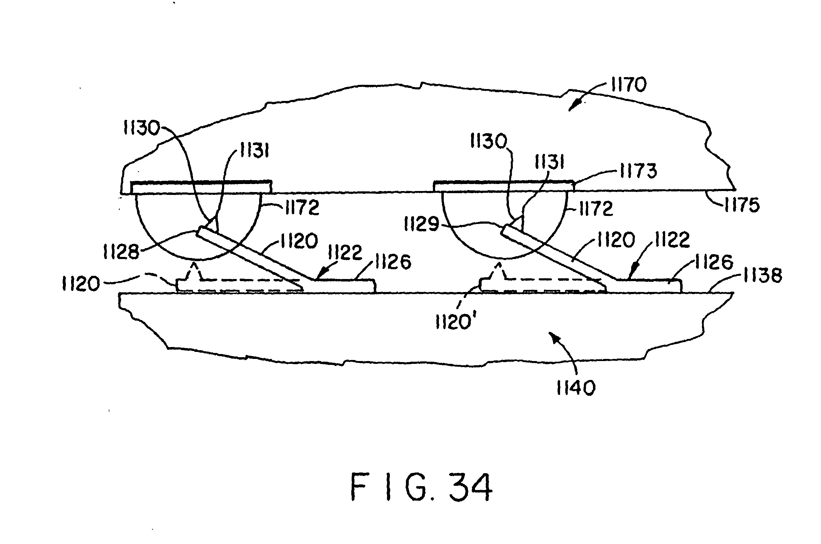

Other contact configurations may be employed. For example, as illustrated in Fig. 34, a microelectronic element or first element 1170 having terminals 1173 on its rear surface 1175 and solder masses 1172 on the terminals may be engaged with a connector or second element 1140 having contacts 1122 in the form of elongated strips on the front surface 1138 of the element body. Each contact 1122 has an anchor portion 1126 connected to the internal electrical element or circuitry (not shown) of second element 1140 and also has a cantilevered elongated tab 1120 having a sharp asperity 1130 at the distal end or tip 1128 of the tab remote from the anchor portion 1126. Asperities 1130 have points 1131, rather than flat surfaces, at their tips remote from the conduit; the points, rather than the edges at the top surface, serve to scratch the mating surface during engagement. In its undeformed condition, each tab extends oblique to surface 1138. When the first element 1170 is forced towards the second element 1140, solder masses 1172 bend the tabs downwardly to the deformed position shown at 1120' in broken lines in Fig. 34. This action causes the tips of the tabs, and particularly the asperities 1130, to move in horizontal directions generally parallel to the surface 1138 of the second element and generally transverse to the motion of the solder masses and first element 1170, thus causing the tips of the tabs and particularly the asparities, to wipe the surfaces of the solder masses. Here again, the solder masses are heated, as by heating both elements. The contact tabs 1120 spring back at least partially towards their undeformed positions and thus penetrate into the solder masses. Once again, after the assembly is cooled and the solder masses resolidified, each solder mass has a contact tab penetrating into it and metallurgically bonded to it.

The contacts described above can be adapted to provide various levels of interengagement force between each contact and the engaged mating electrical element. Interengagement forces between about 0.5 and about 5 grams force per engaged contact or tab are preferred in typical microelectronic applications. The total interengagement force per contact unit, and hence the total interengagement force per solder mass, desirably is between about 2 and about 20 grams force. With the sharp-edged asperity structures discussed above, these relatively small interengagement forces nonetheless provide effective scraping and wiping action. The ability to provide effective scraping action at relatively low force levels is especially significant where numerous contacts must be engaged with numerous solder masses. The degree of wipe or relative movement between the asperity edge and the mating surface during contact engagement can be relatively small, typically less than about 20 microns and usually between about 5 and 10 microns. Even this small relative movement however is enough for the sharp features of the asperity tips to break through the contaminants on the surface of the solder masses.

In the embodiments discussed above, the bonding material in the masses penetrated by the contacts is a solder. Other softenable bonding materials can be employed, such as polymeric materials filled with conductive particles. For example, partially-cured or "B-staged" epoxy resins, polyimide-siloxane resins or thermoplastic polymers filled with metallic particles may be employed. The metallic particles may be formed from metals such as silver, gold, palladium and combinations and alloys thereof, such as silver-palladium, silver alloys and gold alloys.

As will be readily appreciated, numerous other variations and combinations of the features discussed above can be used without departing from the present invention. For example, the bump leads on the microelectronic components need not be either spherical or conical as described above. Cylindrical, hemispherical, oblate and other shapes may be employed. Also, in the process discussed above with reference to Figs. 1-7, the microelectronic component is forced all the way home for the testing step, so as to provide a very secure resilient inter-engagement between the contact projections and bump lead at the time of the testing step. As an alternative, however, the microelectronic element can be engaged with the mounting assembly and with the connector using only a moderate force, so as to partially engage the bump leads with the contacts during the testing step. For example, the assembly may be brought to the condition illustrated in Fig. 5 and then tested. A temporary stop can be interposed between the microelectronic element and the connector during initial assembly and testing, and then removed during final assembly.

As these and other variations and combinations of the features set forth above can be utilized without departing from the invention, the foregoing description of the preferred embodiments should be taken by way of illustration rather than by way of limitation of the invention as defined by the claims.

## Claims

1. A connector (24) for mounting a microelectronic element to a substrate (21) comprising :
(a) a sheetlike body (30) having first and second major surfaces and having a plurality of holes (36) open to said first major surface, said holes being disposed in an array corresponding to an array of bump leads (70) on the microelectronic element to be mounted;
(b) an array of resilient, generally laminar contacts (38, 138, 529) secured to said first major surface of said body in registration with said holes so that each said contact extends inwardly over one said hole from said first major surface, each said contact being adapted to resiliently engage a bump lead inserted into the associated hole; and
(c) an array of terminals (50, 150, 558) electrically connected to said contacts, whereby said microelectronic element can be connected to a substrate by bonding said terminals to said substrate and superposing said microelectronic element on said body so that bump leads on the element protrude into said holes and are engaged by said resilient contacts.

2. A connector as claimed in claim 1 wherein said terminals (38) are disposed in an array on said second major surface of said body.

3. A connector as claimed in claim 2 wherein said array of holes (36) on said first major surface substantially overlaps said array of terminals (38) on said second major surface.

4. A connector as claimed in claim 3 wherein said array of holes (36) and said array of terminals (38) are rectilinear arrays having row and column directions, and wherein said terminals are offset from said holes in diagonal directions, oblique to said row and column directions.

5. A connector as claimed in claim 3 wherein each said hole extends through said body from said first major surface to said second major surface so that each said hole has first-surface and second-surface ends, each said terminal (558) being disposed on said second major surface adjacent the second-surface end of one said hole, the connector further comprising through conductors (552) extending within said hole, the contact and terminal associated with each said hole being connected to one another by the through conductor extending within such hole.

6. A connector as claimed in claim 5 wherein each said through conductor is a hollow conductive via liner (552) substantially lining the associated hole.

7. A connector as claimed in claim 6 wherein each said via liner has a terminal portion (558) flaring outwardly, away from the center of the associated hole at the second-surface end thereof, said terminal portions of said via liner constituting said terminals.

8. A connector as claimed in claim 6 wherein each said via liner has a contact support portion (560) flaring outwardly, away from the center of the associated hole at the first-surface end thereof, each said contact including a ring (520) of a sheetlike metallic contact material overlying the contact support portion of the associated via liner and encircling the opening of the associated hole, each said ring being connected to the contact support portion of the associated via liner remote from the hole, each said contact further including at least one projection (520) formed integrally with the ring and extending inwardly therefrom over the hole.

9. A connector as claimed in claim 8 wherein each said contact includes a plurality of said projections (520) extending inwardly from circumferentially spaced locations on the ring so that said projections of each said contact are cantilevered over the associated hole in the body.

10. A connector as claimed in claim 8 wherein each said contact support has an attachment (566) protruding upwardly, away from said body remote from the associated hole, each said attachment having a locking protrusion (568) overlying the associated ring so as to lock the ring to the contact support.

11. A connector as claimed in claim 1 wherein each said contact includes a ring (526) of a sheetlike metallic contact material overlying the first surface of the body and encircling the opening of the associated hole, each said contact further including at least one projection (520) formed integrally with the ring and extending inwardly therefrom over the hole.

12. A connector as claimed in claim 11 wherein each said projection has an engagement surface facing upwardly, away from said body, so that the engagement surface of each said projection will engage and wipe the bump lead when the bump lead is inserted into the hole and wherein at least some of said engagement surfaces have asperities (530) thereon.

13. A connector as claimed in claim 11 wherein each said contact includes a plurality of said projections (142) extending inwardly from circumferentially spaced locations on the ring, and wherein each said projection extends downwardly from said first surface into the associated hole so that the projections associated with each said hole define a generally conical structure.

14. A connector as claimed in any one of claims 1-13 wherein each said contact includes a structural layer (147) selected from the group consisting of copper, beryllium copper, and phosphor bronze.

15. A connector as claimed in any one of claims 1-13 wherein said contact includes a heat-activatable bonding material (143) selected from the group consisting of solders, eutectic bonding materials, solid state diffusion bonding materials, and composite bonding materials incorporating metal particles in polymers.

16. A connector as claimed in any one of claims 1-13 wherein each said contact includes a resilient metallic contact material and a selectively actuatable bonding material (143) adapted to form a bond only upon application of a preselected activation process, whereby the microelectronic element can be engaged with said contacts without activating said bonding material and then permanently connected to said contacts by applying said activation process.

17. A connector as claimed in any one of claims 1-13 wherein said body (30) is less than about 1mm thick.

18. A connector as claimed in any one of claims 1-13 wherein said holes (36) are disposed in a regular, grid-like pattern at intervals of less than about 2.5 mm.

19. A method of making connections to a microelectronic element having bump (70, 570) leads thereon comprising the step of engaging the element with a connector according to any one of claims 1 to 18 having a sheetlike body and having contacts (30, 529) on a first major surface thereof extending over holes in the body so that the first major surface (32) of the connector body is juxtaposed with the microelectronic element, so that the bump leads on the microelectronic element protrude into the holes in the connector body and so that the bump leads deform the contacts of the connector and are engaged therewith, and bonding said bump leads to said contacts by activating an electrically conductive bonding material (78, 143) at interfaces between said bump leads and said contacts.

20. A method as claimed in claim 19 wherein at least a part of said bonding material (78, 143) is present on said contacts or said bump leads prior to said engaging step.

21. A method as claimed in claim 20 wherein said step of activating said bonding material includes the step of momentarily heating the microelectronic element and connector so as to cause said bonding material to bond at interfaces between said bump leads and said contacts.

22. A method as claimed in claim 21 wherein said bump leads include solder masses (572')and said contacts penetrate into said solder masses during said heating step.

23. A method as claimed in claim 20 further comprising the step of bonding a surface (575') of the microelectronic component to the first surface of the connector body by activating a dielectric bonding material (567) on said first surface of said connector body during said heating step.

24. A method as claimed in any one of claims 19-23 further comprising the step of electrically testing the assembled microelectronic element, connector and substrate prior to said bonding step by actuating the microelectronic element through the connections between said contacts and said bump leads.

25. A method as claimed in claim 24 wherein said microelectronic element remains engaged in the connector from said testing step through said bonding step.

26. A method as claimed in any one of claims 19-23 wherein said engaging step includes the step of forcing each said bump lead through a gap (46) between a plurality of spaced-apart projections on a contact overlying an opening of one said hole in the connector body at said first major surface so that the bump lead forcibly wipes against the projections.

27. A method as claimed in claim 26 wherein said projections have asperities (530) on surfaces which initially face upwardly, away from said body, and wherein said bump leads are scraped by said asperities during said engaging step.

28. A method as claimed in claim 26 wherein said projections of each said contact form a self-locking fit with the bump lead (70) received therein.

29. A method as claimed in any one of claims 19-23 wherein, prior to said engaging step, said sheetlike connector body closely overlies a surface of a substrate (20) with said first major surface facing away from the substrate and the contacts on the connector are electrically connected to the substrate, whereby said engaging step will physically juxtapose said microelectronic element (68) with said substrate and electrically connect the same to said substrate.

30. A method as claimed in claim 29 wherein a plurality of connectors including the aforesaid connector overlie said substrate, and are electrically connected thereto prior to said engaging step, said engaging step including the step of engaging a plurality of microelectronic elements (70, 90) with contacts on said plurality of connectors so that bump leads on said microelectronic elements are received in holes in sheetlike dielectric bodies of all said connectors and so that such bump leads deform electrical contacts on all said connectors, whereby said microelectronic elements will be electrically connected to said substrate and to one another.

31. A method as claimed in claim 30 further comprising the steps of testing the assembled microelectronic elements, connectors and substrates after said engaging step and then permanently securing said microelectronic elements to said connectors without disassembling the microelectronic elements from said connectors.

32. A method as claimed in claim 30 further comprising the step of assembling one or more devices (84) to a carrier (82) having a generally planar undersurface and electrically connecting said one or more devices to bump leads on the undersurface of said carrier to form one said microelectronic element, said engaging step being performed so as to juxtapose the undersurface of said carrier with the first surface of one said connector.

33. An electronic assembly comprising:
(a) a mounting assembly having a substrate (20) with electrically conductive leads therein, means defining at least one mounting surface on said substrate and having holes (36) open to each said mounting surface and extending inwardly toward said substrate, and an array of resilient laminar contacts (38) secured to each said mounting surface in registration with said holes so that each said contact extends over one said hole, said contacts being electrically connected to said leads in said substrate; and
(b) a plurality of microelectronic elements, (68, 90) each such element having a bottom surface and a plurality of bump leads protruding from such bottom surface, each such microelectronic element being mounted on said mounting assembly, the bottom surface of each such element confronting a mounting surface of the mounting assembly, the bump leads of the element protruding into the holes of such mounting surface and resiliently engaging the contacts at such holes so that the bump leads are electrically connected to the leads of said substrate through said contacts, said microelectronic elements being interconnected to one another through said leads of said substrate, said contacts and said bump leads.

34. An assembly as claimed in claim 33 wherein said bump leads of at least one said microelectronic element (68, 90) are bonded to said contacts.

35. An assembly as claimed in claim 33 wherein at least one said microelectronic element (90) is releasably engaged with said mounting assembly, the bump leads of each such element being releasably engaged with said contacts.

36. An assembly as claimed in any one of claims 33-35 wherein said means defining a mounting surface (30) include a first sheetlike dielectric connector body (30) overlying a surface of said substrate, said connector body having a first surface facing away from said substrate and a second surface facing toward said substrate.

37. An assembly as claimed in any one of claims 33-35 wherein said substrate is generally planar and defines oppositely facing top and bottom surfaces, said means for defining at least one mounting surface defining top and bottom mounting surfaces with said holes on said top and bottom surfaces, said contacts overlying said holes on said top and bottom mounting surfaces.

## Patentansprüche

1. Anschluß (24) für die Montage eines mikroelektronischen Elements auf einem Substrat (21), umfassend:
(a) einen blattförmigen Körper (30) mit erster und zweiter Hauptfläche und einer Vielzahl von Löchern (36), die zur ersten Hauptfläche hin offen sind, wobei diese Löcher in einer Anordnung angeordnet sind, die einer Anordnung von Stoßleitungen (70) auf dem zu montierenden mikroelektronischen Element entspricht;
(b) eine Anordnung federnder, allgemein laminarer Kontakte (38, 138, 529), die an der ersten Hauptfläche des Körpers befestigt sind in Positions-Übereinstimmung mit den Löchern, so daß sich jeder Kontakt nach innen über ein Loch der ersten Hauptfläche erstreckt, wobei jeder Kontakt so beschaffen ist, daß er federnd mit einer Stoßleitung gekoppelt wird, die im entsprechenden Loch eingesetzt ist; und
(c) eine Anordnung von Klemmen (50, 150, 558), die elektrisch mit den Kontakten verbunden sind, wobei das mikroelektronische Element mit einem Substrat verbunden werden kann, indem die Klemmen mit dem Substrat verbunden und das mikroelektronische Element auf dem Körper so aufgesetzt wird, daß Stoßleitungen auf dem Element in die Löcher hineinragen und von den federnden Kontakten erfaßt werden.

2. Anschluß gemäß Anspruch 1, wobei die Klemmen (38) in einer'Gruppe auf der zweiten Hauptfläche des Körpers angeordnet sind.

3. Anschluß gemäß Anspruch 2, wobei die Anordnung der Löcher (36) auf der ersten Hauptfläche im wesentlichen die Anordnung der Klemmen (38) auf der zweiten Hauptfläche überlappt.

4. Anschluß gemäß Anspruch 3, wobei die Löcheranordnung (36) und die Klemmenanordnung (38) rechteckige Matrixanordnungen mit Reihen- und Spalten-Richtungen sind, und wobei die Klemmen gegenüber den Löchern in diagonalen Richtungen, die relativ zu den Reihen- und Spalten-Richtungen schräg liegen, versetzt sind.

5. Anschluß gemäß Anspruch 3, wobei sich jedes Loch durch den Körper von der ersten zur zweiten Hauptfläche erstreckt, so daß jedes Loch je ein Ende auf der ersten und auf der zweiten Fläche aufweist, jede Klemme (558) auf der zweiten Hauptfläche neben dem Zweithauptflächenende von einem Loch positioniert ist und der Anschluß zusätzlich Durchgangsleitungen (552) aufweist, die sich im Loch erstrecken, wobei der Kontakt und die Klemme, die jedem Loch zugeordnet sind, mittels der sich im Loch erstreckenden Durchgangsleitung miteinander verbunden sind.

6. Anschluß gemäß Anspruch 5, wobei jede Durchgangsleitung eine hohle leitende Durchgangsbeschichtung (552) ist, die im wesentlichen die Innenfläche des entsprechenden Lochs bedeckt.

7. Anschluß gemäß Anspruch 6, wobei jede Durchgangsbeschichtung einen sich nach außen erweiternden Klemmenabschnitt (558) aufweist, der sich weg von der Mitte des entsprechenden Lochs an dessen Ende auf der zweiten Fläche aufweitet, wobei die Klemmenabschnitte der Durchgangsbeschichtungen die Klemmen bilden.

8. Anschluß gemäß Anspruch 6, wobei jede Durchgangsbeschichtung einen Kontaktstützabschnitt (560) aufweist, der sich nach außen erweitert, weg von der Mitte des entsprechenden Lochs an dessen Ende auf der ersten Fläche davon aufweitend, wobei jeder Kontakt auch einen Ring (520) eines blattförmigen metallischen Kontaktmaterials aufweist, welches über dem Kontaktstützabschnitt der zugehörigen Durchgangsbeschichtung liegt und die Öffnung des zugehörigen Lochs umschließt, wobei jeder Ring mit dem Kontaktstützabschnitt der zugeordneten Durchgangsbeschichtung entfernt vom Loch verbunden ist, wobei jeder Kontakt zusätzlich wenigstens eine Projektion (520) aufweist, die integriert mit dem Ring gebildet ist und sich von dort nach innen über das Loch erstreckt.

9. Anschluß gemäß Anspruch 8, wobei jeder Kontakt eine Mehrzahl solcher Projektionen (520) aufweist, die sich nach innen von Stellen, verteilt auf dem Umfang des Rings sind, erstrecken, so daß die Projektionen von jedem Kontakt über dem zugeordneten Loch im Körper ausgekragt sind.

10. Anschluß gemäß Anspruch 8, wobei jede Kontaktstütze einen nach oben, weg vom Körper, ragenden Ansatz (566) aufweist, entfernt vom zugeordneten Loch, wobei jeder Ansatz einen verriegelnden Vorsprung (568) aufweist, der über dem zugeordneten Ring liegt und den Ring an der Kontaktstütze verriegelt.

11. Anschluß gemäß Anspruch 1, wobei jeder Kontakt auch einen Ring (526) aus einem blattförmigen metallischen Kontaktmaterial aufweist, welcher über der ersten Fläche des Körpers liegt und die Öffnung des zugeordneten Lochs umschließt, wobei jeder Kontakt zusätzlich wenigstens eine Projektion (520) aufweist, die integriert mit dem Ring gebildet ist und sich von dort nach innen über das Loch erstreckt.

12. Anschluß gemäß Anspruch 11, wobei die Projektion eine nach oben, weg vom Körper gerichtete Kopplungsfläche aufweist, so daß die Kopplungsfläche von jeder Projektion mit der Stoßleitung koppelt und über sie streift, wenn die Stoßleitung in das Loch eingeführt wird, und wobei wenigstens einige der Kopplungsflächen darauf befindliche Rauheiten (530) aufweisen.

13. Anschluß gemäß Anspruch 11, wobei jeder Kontakt eine Mehrzahl der Projektionen (142) aufweist, die sich nach innen von auf dem Ringumfang verteilten Stellen erstrecken, und wobei sich jede Projektion von der ersten Fläche nach unten in das zugeordnete Loch erstreckt, so daß die jedem Loch zugeordneten Projektionen eine im wesentlichen konische Struktur definieren.

14. Anschluß gemäß Anspruch 1 bis 13, wobei jeder Kontakt eine Strukturchicht (147) aufweist, die aus der Materialgruppe Kupfer, Berylliumkupfer und Phosphorbronze selektiert ist.

15. Anschluß gemäß Anspruch 1 bis 13, wobei der Kontakt ein thermisch aktivierbares Verbindungsmaterial (143) aufweist, welches aus der Materialgruppe selektiert ist, die Lötmittel, eutektische Verbindungsmaterialien, Festkörperdiffusions-Verbindungsmaterialien und Mehrkomponenten-Verbindungsmaterialien, darunter auch Metallpartikel in Polymeren, umfaßt.

16. Anschluß gemäß Anspruch 1 bis 13, wobei jeder Kontakt ein federndes metallisches Kontaktmaterial und ein selektiv aktivierbares Verbindungsmaterial (143) aufweist, welches adaptiert ist, um nur durch Anwendung eines vorselektierten Aktivierungsverfahrens eine Verbindung herzustellen, wobei das mikroelektronische Element mit den Kontakten ohne Aktivierung des Verbindungsmaterials gekoppelt werden kann, wonach der permanente Anschluß an die Kontakte durch Anwendung des Aktivierungsverfahrens erfolgt.

17. Anschluß gemäß Anspruch 1 bis 13, wobei der Körper (30) weniger als etwa 1 mm dick ist.

18. Anschluß gemäß Anspruch 1 bis 13, wobei die Löcher (36) in einer regulären, gitterförmigen Anordnung mit Abständen von weniger als etwa 2,5 mm angelegt sind.

19. Verfahren zur Herstellung von Verbindungen an einem mikroelektronischen Element, auf welchem sich Stoßleitungen (70, 570) befinden, welches den Schritt des Koppeln des Elements mit einem Anschluß gemäß Anspruch 1 bis 18 umfaßt, der einen blattförmigen Körper aufweist, welcher Kontakte (30, 529) auf einer ersten Hauptfläche davon aufweist, die sich über Löcher im Körper erstrecken, so daß die erste Hauptfläche (32) des Anschlußkörpers sich dem mikroelektronischen Element gegenüber befindet, so daß die Stoßleitungen auf dem mikroelektronischen Element in die Löcher im Anschlußkörper hineinragen und so, daß die Stoßleitungen die Kontakte des Anschlusses deformieren und so damit gekoppelt sind, und die Stoßleitungen werden mit den Kontakten verbunden, indem ein elektrisch leitendes Verbindungsmaterial (78, 143) an den Kontaktstellen zwischen den Stoßleitungen und den Kontakten aktiviert wird.

20. Verfahren gemäß Anspruch 19, wobei wenigstens ein Teil des Verbindungsmaterials (78, 143) auf den Kontakten oder auf den Stoßleitungen vor dem Kopplungsschritt vorhanden ist.

21. Verfahren gemäß Anspruch 20, wobei der Schritt des Aktivierens des Verbindungsmaterials den Schritt der kurzzeitigen Aufheizung des mikroelektronischen Elements und des Anschlusses aufweist, um das Verbindungsmaterial zu veranlassen, eine Verbindung an den Kontaktstellen zwischen den Stoßleitungen und den Kontakten herzustellen

22. Verfahren gemäß Anspruch 21, wobei die Stoßleitungen Lotmassen (572') aufweisen und die Kontakte während des Aufheizschritts in die Lotmassen eindringen.

23. Verfahren gemäß Anspruch 20, zusätzlich aufweisend den Schritt des Verbindens einer Fläche (575') des mikroelektronischen Elements mit der ersten Fläche des Anschlußkörpers durch Aktivieren eines dielektrischen Verbindungsmaterials (567) auf der ersten Fläche des Anschlußkörpers während des Aufheizschritts.

24. Verfahren gemäß Ansprüche 19 bis 23, zusätzlich aufweisend den Schritt der elektrischen Prüfung des zusammengebauten mikroelektronischen Elements, des Anschlusses und des Substrats vor dem Verbindungsschritt, indem das mikroelekronische Element über die Verbindungen zwischen den Kontakten und den Stoßleitungen angesprochen wird.

25. Verfahren gemäß Anspruch 24, wobei das mikroelektronische Element im Anschluß vom Prüfschritt bis zum Verbindungsschritt gekoppelt bleibt.

26. Verfahren gemäß Anspruch 19 bis 23, wobei der Kopplungsschritt auch den Schritt des Zwingens der Stoßleitung durch eine Lücke (46) zwischen einer Mehrzahl von in Abständen auf einem Kontakt verteilten Projektionen umfaßt, wobei der Kontakt über einer Öffnung eines Lochs im Anschlußkörper auf der ersten Hauptfläche liegt, so daß die Stoßleitung mit Kraftschluß gegen die Projektionen schleift.

27. Verfahren gemäß Anspruch 26, wobei die Projektionen rauhe Stellen (530) aufweisen auf Flächen, die zunächst nach oben, weg vom Körper, weisen, und wobei die Stoßleitungen von den Rauheiten während des Kopplungsschritts gescheuert werden.

28. Verfahren gemäß Anspruch 26, wobei die Projektionen von jedem Kontakt eine selbstverriegelnden Einpassung mit der darin aufgenommenen Stoßleitung (70) bilden.

29. Verfahren gemäß Anspruch 19 bis 23, wobei vor dem Kopplungsschritt der blattförmige Anschlußkörper über einer Fläche eines Substrats (20) liegt, wobei die erste Hauptfläche vom Substrat weg gerichtet ist und die Kontakte auf dem Anschluß elektrisch mit dem Substrat verbunden sind, wobei der Kopplungsschritt das mikroelektronische Element (68) physisch in Position gegenüber dem Substrat bringt und es elektrisch mit dem Substrat verbindet.

30. Verfahren gemäß Anspruch 29, wobei eine Mehrzahl von Anschlüssen, einschließlich des zuvor erwähnten Anschlusses, über dem Substrat liegen und elektrisch damit verbunden werden vor dem Kopplungsschritt, wobei der Kopplungsschritt auch den Schritt des Koppelns einer Mehrzahl mikroelektronischer Elemente (70, 90) mit der Mehrzahl von Anschlüssen umfaßt, so daß die Stoßleitungen auf den mikroelektronischen Elementen von den Löchern in den blattförmigen dielektrischen Körpern aller Anschlüsse aufgenommen werden, und so daß die Stoßleitungen die elektrischen Kontakte auf allen Anschlüssen deformieren, womit die mikroelektronischen Elemente mit dem Substrat und miteinander elektrisch verbunden werden.

31. Verfahren gemäß Anspruch 30, zusätzlich aufweisend die Schritte des Prüfens der zusammengebauten mikroelektronische Elemente, Anschlüsse und Substrate nach dem Kopplungsschritt, und danach permanente Verbindung der mikroelektronische Elemente mit den Anschlüssen ohne Trennung der mikroelektronischen Elemente von den Anschlüssen.

32. Verfahren gemäß Anspruch 30, zusätzlich aufweisend den Schritt des Zusammenbaus von einem oder mehreren Vorrichtungen (84) mit einem Träger (82) mit einer im wesentlichen flachen unterseitigen Fläche, und elektrisches Verbinden des einen oder der mehreren Vorrichtungen mit den Stoßleitungen auf der unterseitigen Fläche des Trägers, um ein mikroelektronisches Element zu bilden, wobei der Kopplungsschritt so ausgeführt wird, daß die unterseitige Flache des Trägers in Position gegenüber der ersten Fläche eines Anschlusses gebracht wird.

33. Elektronischer Zusammenbau, umfassend:
(a) eine Montageeinheit, welche ein Substrat (20) mit elektrisch leitenden Leitungen darin, Mittel zum Definieren von wenigstens einer Montagefläche auf dem Substrat und Löcher (36) aufweist, die zu jeder Montagefläche offen sind und sich nach innen in Richtung zum Substrat erstrecken, und eine Anordnung von federnden laminaren Kontakten (38) aufweist, die an jeder Montagefläche in Übereinstimmung mit den Löchern befestigt sind, so daß jeder Kontakt sich über ein Loch erstreckt, wobei die Kontakte mit den Leitungen im Substrat elektrisch verbunden sind; und
(b) eine Mehrzahl mikroelektronischer Elemente (68,90), wobei jedes solches Element eine untere Fläche und eine Mehrzahl von Stoßleitungen aufweist, die aus der unteren Fläche herausragen, wobei jedes solches mikroelektronisches Element auf der Montageeinheit montiert ist, wobei die untere Fläche von jedem solchen Element einer Montagefläche der Montageeinheit begegnet, wobei die Stoßleitungen des Elements in die Löcher der Montagefläche hineinragen und mit den Kontakten an den Löchern koppeln, so daß die Stoßleitungen elektrisch mit den Leitungen des Substrats über die Kontakte verbunden sind, wobei die mikroelektronischen Elemente miteinander verbunden sind über die Leitungen des Substrats, die Kontakte und die Stoßleitungen.

34. Zusammenbau gemäß Anspruch 33, wobei die Stoßleitungen von wenigstens einem mikroelektronischen Element (68, 90) mit den Kontakten verbunden sind.

35. Zusammenbau gemäß Anspruch 33, wobei wenigstens ein mikroelektronisches Element (90) trennbar mit der Montageeinheit gekoppelt ist, wobei die Stoßleitungen von jedem solchen Element trennbar mit den Kontakten gekoppelt sind.

36. Zusammenbau gemäß Anspruch 33 bis 35, wobei das Mittel zum Definieren einer Montagefläche (30) einen ersten blattförmigen dielektrischen Anschlußkörper (30) umfaßt, der über einer Fläche des Substrats liegt, wobei der Anschlußkörper eine erste Fläche, die vom Substrat weg gerichtet ist, und eine zweite Fläche, die dem Substrat zugewendet ist, aufweist.

37. Zusammenbau gemäß Anspruch 33 bis 35, wobei das Substrat im wesentlichen flach ist und die in entgegensetzten Richtungen weisenden, oberen und unteren Flächen definiert, wobei die Mittel zum Definieren von wenigstens einer Montagefläche die obere und die untere Montagefläche definieren mit den Löchern auf den oberen und unteren Flächen, wobei die Kontakte über den Löchern auf den oberen und unteren Flächen liegen.

## Revendications

1. Connecteur (24) en vue du montage d'un élément microélectronique sur un substrat (21) comportant :
(a) un corps sous forme de feuille (30) possédant des première et seconde surfaces principales et possédant une pluralité de trous (36) ouverts sur ladite première surface principale, lesdits trous étant disposés en un réseau correspondant à un réseau de câbles d'amortissement (70) sur l'élément microélectronique devant être monté ;
(b) un réseau de contacts généralement laminaires élastiques (38, 138, 529) fixés à ladite première surface principale dudit corps en relation avec lesdits trous de sorte que chacun desdits contacts s'étend vers l'intérieur à travers un desdits trous depuis ladite première surface principale, chacun desdits contacts étant adapté pour venir en contact de façon élastique d'un câble d'amortissement inséré dans le trou associé ; et
(c) un réseau de bornes (50, 150, 558) reliées électriquement auxdits contacts, dans lequel ledit élément microélectronique peut être connecté au substrat par soudage desdites bornes audit substrat et en superposant ledit élément microélectronique sur ledit corps de sorte que les câbles d'amortissement sur l'élément font saillie dans lesdits trous et viennent en contact desdits contacts élastiques.

2. Connecteur selon la revendication 1, dans lequel lesdites bornes (38) sont disposées en un réseau sur ladite seconde surface principale dudit corps.

3. Connecteur selon la revendication 2, dans lequel ledit réseau de trous (36) sur ladite première surface principale recouvre sensiblement ledit réseau de bornes (38) sur ladite seconde surface principale.

4. Connecteur selon la revendication 3, dans lequel ledit réseau de trous (36) et ledit réseau de bornes (38) sont des réseaux rectilignes possédant des directions de rangée et de colonne, et dans lequel lesdites bornes sont décalées par rapport auxdits trous dans les directions diagonales, obliques auxdites directions de rangée et de colonne.

5. Connecteur selon la revendication 3, dans lequel chacun desdits trous s'étend à travers ledit corps depuis ladite première surface principale vers ladite seconde surface principale de sorte que chacun desdits trous possède des extrémités de première surface et de seconde surface, chacune desdites bornes (558) étant disposée sur ladite seconde surface principale adjacente à l'extrémité de seconde surface d'un desdits trous, le connecteur comportant en outre des conducteurs traversants (552) s'étendant à l'intérieur dudit trou, le contact et la borne associés à chacun desdits trous étant connectés à un autre par le conducteur traversant s'étendant à l'intérieur de ce trou.

6. Connecteur selon la revendication 5, dans lequel chacun desdits conducteurs traversants est une douille d'interconnexion conductrice creuse (552) recouvrant sensiblement le trou associé.

7. Connecteur selon la revendication 6, dans lequel chacune desdites douilles d'interconnexion possède une partie de borne (558) s'évasant vers l'extérieur, en s'éloignant du centre du trou associé à son extrémité de seconde surface, lesdites parties de borne de ladite douille d'interconnexion constituant lesdites douilles.

8. Connecteur selon la revendication 6, dans lequel chacune desdites douilles d'interconnexion possède une partie de support de contact (560) s'évasant vers l'extérieur, en s'éloignant du centre du trou associé à son extrémité de première surface, chacun desdits contacts comprenant un anneau (520) d'un matériau de contact métallique sous forme de feuille recouvrant la partie de support de contact de la douille d'interconnexion associée et encerclant l'ouverture du trou associé, chacun desdits anneaux étant relié à la partie de support de contact de la douille d'interconnexion associée éloignée du trou, chacun desdits contacts comprenant en outre au moins une partie saillante (520) formée intégralement avec l'anneau et s'en étendant vers l'intérieur au-dessus du trou.

9. Connecteur selon la revendication 8, dans lequel chacun desdits contacts comprend une pluralité desdites parties saillantes (520) s'étendant vers l'intérieur depuis des endroits espacés circonférentiellement sur l'anneau de sorte que les parties saillantes de chacun desdits contacts sont en porte-à-faux au-dessus du trou associé dans le corps.

10. Connecteur selon la revendication 8, dans lequel chacun desdits supports de contact possède une fixation (556) faisant saillie vers le haut, en s'éloignant dudit corps éloigné dudit trou associé, chacune desdites fixations possédant une partie saillante de blocage (568) recouvrant l'anneau associé de manière à bloquer l'anneau sur le support de contact.

11. Connecteur selon la revendication 1, dans lequel chacun desdits contacts comprend un anneau (526) en matériau de contact métallique sous forme de feuille recouvrant la première surface du corps et encerclant l'ouverture du trou associé, chacun desdits contacts comportant en outre au moins une partie saillante (520) formée intégralement avec l'anneau et s'en étendant vers l'intérieur par dessus le trou.

12. Connecteur selon la revendication 11, dans lequel chacune desdits parties saillantes possède une surface de contact en vis-à-vis vers le haut, s'éloignant dudit corps, de sorte que la surface de contact de chacune desdites parties saillantes vient en contact et frotte le câble d'amortissement lorsque le câble d'amortissement est inséré dans le trou et dans lequel au moins certaines desdites surfaces de contact possèdent des aspérités (530).

13. Connecteur selon la revendication 11, dans lequel chacun desdits contacts comprend une pluralité desdites parties saillantes (142) s'étendant vers l'intérieur depuis des endroits espacés circonférentiellement sur l'anneau, et dans lequel chacune desdites parties saillantes s'étend vers le bas depuis ladite première surface dans le trou associé de sorte que les parties saillantes associées à chacun desdits trous définissent une structure généralement conique.

14. Connecteur selon l'une quelconque des revendications 1 à 13, dans lequel chacun desdits contacts comprend une couche de structure (147) choisie parmi le groupe constitué du cuivre, du cuivre au béryllium, et du bronze au phosphore.

15. Connecteur selon l'une quelconque des revendications 1 à 13, dans lequel ledit contact comprend un matériau de soudage pouvant être activé thermiquement (143) choisi par le groupe constitué de soudures, de matériaux de soudure eutectiques, de matériaux de soudure à diffusion d'état solides, et des matériaux de soudure composites incorporant des particules métalliques dans des polymères.

16. Connecteur selon l'une quelconque des revendications 1 à 13, dans lequel chacun desdits contacts comprend un matériau de contact métallique élastique et un matériau de soudage pouvant agir sélectivement (143) adapté pour forme une soudure uniquement sur une application d'un processus d'activation présélectionné, dans lequel l'élément microélectronique peut venir en contact avec lesdits contacts sans activer ledit matériau de soudage et être relié ensuite en permanence auxdits contacts en appliquant ledit processus d'activation.

17. Connecteur selon l'une quelconque des revendications 1 à 13, dans lequel ledit corps (30) a une épaisseur inférieure à environ 1 mm.

18. Connecteur selon l'une quelconque des revendications 1 à 13, dans lequel lesdits trous (36) sont disposés en une configuration semblable à une grille régulière à des intervalles inférieurs à environ 2,5 mm.

19. Procédé de réalisation de connexions sur un élément microélectronique possédant des câbles d'amortissement (70, 570) comprenant l'étape de mise en contact de l'élément avec un connecteur selon l'une quelconque des revendications 1 à 18 possédant un corps sous forme de feuille et possédant des contacts (30, 529) sur sa première surface principale s'étendant au-dessus des trous dans le corps de sorte que la première surface principale (32) d'un corps de connecteur est juxtaposée à l'élément microélectronique, de sorte que les câbles d'amortissement sur l'élément microélectronique font saillie dans les trous dans le corps de connecteur et de sorte que les câbles d'amortissement déforment les contacts du connecteur et viennent en contact, et de soudage desdits câbles d'amortissement auxdits contacts en activant un matériau de soudage électriquement conducteur (78, 143) à des interfaces entre lesdits câbles d'amortissement et lesdits contacts.

20. Procédé selon la revendication 19, dans lequel au moins une partie dudit matériau de soudage (78, 143) est présent sur lesdits contacts ou lesdits câbles d'amortissement avant ladite étape de mise en contact.

21. Procédé selon la revendication 20, dans lequel ladite étape d'activation dudit matériau comprend l'étape consistant à chauffer momentanément l'élément microélectronique et le connecteur de manière à amener ledit matériau de soudage à effectuer une soudure aux interfaces entre lesdits câbles d'amortissement et lesdits contacts.

22. Procédé selon la revendication 21, dans lequel lesdits câbles d'amortissement comprennent des masses de soudure (572') et lesdits contacts pénètrent dans lesdits masses de soudure au cours de l'étape de chauffage.

23. Procédé selon la revendication 20 comportant en outre l'étape consistant à souder une surface (575') de l'élément microélectronique à la première surface du corps de connecteur en activant un matériau de soudure diélectrique (567) sur ladite première surface dudit corps de connecteur au cours de ladite étape de chauffage.

24. Procédé selon l'une quelconque des revendications 19 à 23, comportant en outre l'étape consistant à tester électriquement l'élément microélectronique, le connecteur et le substrat assemblés avant ladite étape de soudage en activant l'élément microélectronique par l'intermédiaire des connexions entre lesdits contacts et lesdits câbles d'amortissement.

25. Procédé selon la revendication 24, dans lequel ledit élément microélectronique reste en contact avec le connecteur depuis ladite étape de test par l'intermédiaire de ladite étape de soudage.

26. Procédé selon l'une quelconque des revendications 19 à 23, dans lequel ladite étape de mise en contact comprend l'étape consistant à forcer ledit câble d'amortissement à travers un intervalle (46) entre une pluralité de parties saillantes espacées sur un contact recouvrant une ouverture d'un desdits trous dans le corps de connecteur à ladite première surface principale de sorte que le câble d'amortissement frotte à force contre les parties saillantes.

27. Procédé selon la revendication 26, dans lequel lesdites parties saillantes possèdent des aspérités (530) sur leurs surfaces qui font face principalement vers le haut, en s'éloignant dudit corps, et dans lequel lesdits câbles d'amortissement sont raclés par lesdites aspérités au cours de l'étape de mise en contact.

28. Procédé selon la revendication 26, dans lequel lesdites parties saillantes de chacun desdits contacts forment une fixation de blocage avec les câbles d'amortissement (70) reçus à l'intérieur.

29. Procédé selon l'une quelconque des revendication 19 à 23, dans lequel avant ladite étape de mise en contact, ledit corps de connecteur sous forme de feuille recouvre étroitement une surface d'un substrat (20) avec ladite première surface principale en vis-à-vis éloignée du substrat et les contacts sur le connecteur sont reliés électriquement au substrat, dans lequel ladite étape de mise en contact juxtapose physiquement ledit élément microélectronique (68) avec ledit substrat et relie électriquement le même audit substrat.

30. Procédé selon la revendication 29, dans lequel une pluralité de connecteurs comprenant le connecteur précité recouvrent ledit substrat, et y sont électriquement reliés avant ladite étape de mise en contact, ladite étape de mise en contact comprenant l'étape consistant à mettre en contact une pluralité d'éléments microélectroniques (70, 90) avec des contacts sur ladite pluralité de connecteurs de sorte que les câbles d'amortissement sur lesdits éléments microélectroniques sont reçus dans des trous dans les corps diélectriques sous forme de feuille de tous lesdits connecteurs et de sorte que ces câbles d'amortissement déforment les contacts électriques sur tous lesdits connecteurs, dans lequel lesdits éléments microélectroniques sont reliés électriquement audit substrat et l'un à l'autre.

31. Procédé selon la revendication 30, comportant en outre les étapes consistant à tester les éléments microélectroniques, connecteurs et substrats assemblés après ladite étape de mise en contact et ensuite à fixer de façon permanente lesdits éléments microélectroniques auxdits connecteurs sans désassembler les éléments microélectroniques desdits connecteurs.

32. Procédé selon la revendication 30, comportant en outre l'étape consistant à assembler un dispositif ou plus (84) sur un support (82) possédant une surface inférieure généralement plane et à relier électriquement ledit dispositif ou plus aux câbles d'amortissement sur la surface inférieure dudit support pour former ledit élément microélectronique, ladite étape de mise en contact étant réalisée de manière à juxtaposer la surface inférieure audit support avec la première surface d'un desdits connecteurs.

33. Assemblage électronique comportant :
(a) un assemblage de montage possédant un substrat (20) comprenant des câbles électriquement conducteurs, des moyens définissant au moins une surface de montage sur ledit substrat et possédant des trous (36) ouverts sur chacune desdites surfaces de montage et s'étendant vers l'intérieur vers ledit substrat, et un réseau de contacts laminaires élastiques (38) fixés à chacune desdites surfaces de montage en relation avec lesdits trous de sorte que chacun desdits contacts s'étend au-dessus d'un desdits trous, lesdits contacts étant reliés électriquement auxdits câbles dans ledit substrat ; et
(b) une pluralité d'éléments microélectroniques (68, 90), chacun de ces éléments possédant une surface inférieure et une pluralité de câbles d'amortissement faisant saillie depuis cette surface inférieure, chacun de ces éléments microélectroniques étant monté sur ledit assemblage de montage, la surface inférieure de chacun de ces éléments étant en vis-à-vis d'une surface de montage, les câbles d'amortissement de l'élément faisant saillie dans les trous de cette surface de montage et venant en contact de façon élastique avec les contacts dans ces trous de sorte que les câbles d'amortissement sont reliés électriquement aux câbles dudit substrat par l'intermédiaire desdits contacts, lesdits éléments microélectroniques étant interconnectés l'un à l'autre par l'intermédiaire desdits câbles dudit substrat, desdits contacts et desdits câbles d'amortissement.

34. Assemblage selon la revendication 33, dans lequel lesdits câbles d'amortissement d'au moins un desdits éléments microélectroniques (68, 90) sont soudés auxdits contacts.

35. Assemblage selon la revendication 33, dans lequel au moins un desdits éléments microélectroniques (90) est mis en contact de façon détachable avec ledit assemblage de montage, les câbles d'amortissement de chacun de ces éléments étant mis en contact de façon détachable avec lesdits contacts.

36. Assemblage selon l'une quelconque des revendications 33 à 35, dans lequel lesdits moyens définissant une surface de montage (30) comprennent un premier corps de connecteur diélectrique sous forme de feuille (30) recouvrant une surface dudit substrat, ledit corps de connecteur possédant une première surface en vis-à-vis éloignée dudit substrat et une seconde surface en vis-à-vis vers ledit substrat.

37. Assemblage selon l'une quelconque des revendications 33 à 35, dans lequel ledit substrat est généralement planaire et définit des surfaces inférieure et supérieure se faisant face de façon opposée, lesdits moyens pour définir au moins une surface de montage définissant les surfaces de montage supérieure et inférieure avec lesdits trous sur lesdites surfaces supérieure et inférieure, ledit contacts recouvrant lesdits trous sur lesdites surfaces de montage supérieure et inférieure.
